# EUROPEAN PATENT SPECIFICATION

(11) **EP 2 041 750 B1**
(45) Date of publication and mention of the grant of the patent: **25.08.2010**
(21) Application number: 07812687.7
(22) Date of filing: 06.07.2007
(51) Int. Cl.: G11C 7/12, G11C 7/06, G11C 7/00

(54) **MEMORIES WITH FRONT END PRECHARGE**
SPEICHEREINHEITEN MIT FRONT-END-VORLADUNG
MÉMOIRES AVEC PRÉCHARGE FRONTALE

(30) Priority: 07.07.2006 US 819296 P; 29.06.2007 US 771853
(43) Date of publication of application: 01.04.2009
(73) Proprietor: S. Aqua Semiconductor, LLC, Wilmington, DE 19808 (US)
(72) Inventor: RAO, G.R. Mohan, Richardson TX 75080 (US)
(74) Representative: Kazi, Ilya
(86) International application number: PCT/US2007/072974
(87) International publication number: WO 2008/006075

(56) References cited:
- US-A- 5 636 174
- US-B1- 6 529 412
- US-B1- 6 779 076
- US-B2- 6 512 715

## Description

### FIELD OF THE INVENTION

Embodiments of the disclosure relate to integrated circuits, in particular to digital memory banks with selective precharge.

### BACKGROUND OF THE INVENTION

Electronic systems are used in numerous devices including Personal Computers (PC), servers, routers, hubs, switches, line cards, cellular telephones, Personal Data Assistants (PDA), electronic gaming devices, High Definition Televisions (HDTV), as well as industrial devices, automotive devices, and others. The primary technology drivers for these electronic systems are digital logic and control, semiconductor memory, Input/Output (I/O) and mixed signal (analog and digital) technologies. Examples of stand alone products include micro processors/controllers, Dynamic Random Access Memory (DRAM), SRAM, flash EEPROM, A/D converters etc. Examples of embedded products include multiple integrated circuits (IC) as SIC (System-In-Chip) or monolithic IC as SOC (System-On-Chip).

For well over three decades, semiconductor memories - such as, for example, DRAM'S, SRAM'S, ROM'S, EPROM'S, EEPROM'S, Flash EEPROM'S, Ferroelectric RAM'S, MAGRAM'S and others - have played a vital role in many electronic systems. Their functions for data storage, code (instruction) storage, and data retrieval/access (Read/Write) continue to span a wide variety of applications. Usage of these memories in both stand alone/discrete memory product forms, as well as embedded forms such as, for example, memory integrated with other functions like logic, in a module or monolithic IC, continues to grow. Cost, operating power, bandwidth, latency, ease of use, the ability to support broad applications (balanced vs. imbalanced accesses), and nonvolatility are all desirable attributes in a wide range of applications.

From a few kilobits (kb) of storage on a monolithic IC in the 1970's, semiconductor technology has come very far in density per memory chip. 1 Gigabit (GB) per monolithic IC is practical today in volatile Read/Write RAM'S like DRAM'S, as well as nonvolatile Read/Write memories like flash EEPROM. However, the granularity of access has not kept pace. Even though multibank IC's are available today, no more than 32 bits can be accessed at a time. Effectively, only one bank is available at a time for R/W; the other banks are non-accessible for substantially simultaneous operations. Access and cycle times have improved providing higher bandwidth with restrictions like 'column pre-fetch', 'open page' and 'specialized I/O interface' (DDR, QDR, RambusTM) etc. However, random latency - the ability to access any random location anywhere in the memory - is still an issue. With low voltage and battery operation becoming mandatory for portability, significant strides have yet to be made towards reducing power and latency. For example, mobile SDRAMs, such as for example those offered by Micron and others, have made some steps in reducing "stand by power". However, reducing operating power still remains an issue in such memories.

In a commercially available DRAM, organized row by column such as in a matrix, when a row is opened (equal to one "page") between one to four kilobits are available for fast random access once the "page" is opened. However, communications memories are not efficient with open page architecture for various reasons. First, unlike unbalanced Read/Write in computing system memory where Reads may dominate Writes by better than three to one, communication memories require balanced Read/Write where the number of Reads roughly equal the number of Writes. Second, the egress (outgoing) of packet memory content is completely random and unpredictable in communications memory. Thus, for these reasons random latency for any packet, or part of a packet, dictates useful bandwidth rather than the ability to quickly access a restricted addressing space such as in an open page. Additionally, before a new page can be opened (as in a DRAM), the existing or current page has to be closed, and the entire bank precharged. Hence, if an individual bank has 64 Mb density, even if one needs to only access 16 new bits in a row, one has to precharge the whole bank, which uses power and increases the temperature of the memory device.

Although, bandwidth, latency, cost, power, and form factor are all important, low power is key for mobile applications. Reducing operating power, as density and speeds increase for new generation devices, is a major concern. Asynchronous operation in DRAM'S, SRAM'S and flash EEPROM'S is the currently preferred option to reduce operating power - however, it penalizes access time and performance. Synchronous operation, on the other hand, requires 'activation and precharge of millions of nodes in an integrated circuit (IC) thereby incurring high power costs. In CMOS designs, for example, operating power is approximately equal to CV2f, where f is the frequency, C is the capacitance (of all kinds) and V is the voltage. Reducing V and C has limits. For better performance generally f has to increase, making it more difficult to reduce operating power at the same time.

Multibank memories are common in DRAM, SRAM and flash. Predetermined (e.g. prefetched) bursts of data and "open page", have been common in both DRAM and SRAM (such as for example Rambus™, DDR, QDR and others) to improve bandwidth. RLDRAM™ and FCRAM™ are two examples of bandwidth and latency-thrust. Round-robin schemes may also be used to reduce power but do not allow for random row access since access is restricted to each memory bank in a predetermined order. Thus, random row access time is lengthened on average.

In US Patent No. 5,828,610 dated October 27, 1998 issued to Rogers et al, a Static RAM (SRAM) is disclosed. The SRAM is described as being capable of selectively precharging a data word prior to a read access operation on that data word, in order to conserve power. However, there is no teaching or suggestion for selectively precharging prior to a write access operation. It also does not teach or suggest a method of selectively precharging a single column of memory cells. Further, despite showing selective precharging, the operation of Roger's SRAM, as well as other standard memory not utilizing selective precharge, requires that one access cycle complete before another memory segment can be accessed. This manner of operation results in added latency. Additionally, SRAM in general is not as dense as other forms of memory, such as DRAM. Therefore, SRAM is less affected by soft errors than are more dense forms of memory such as modem DRAM. Beside sensitivity to soft errors, traditional SRAM unlike DRAM, typically does not have to support various kinds of burst mode operations.

US Patent No. 5,636,174 whereon the preamble of claim 1 is based discloses a memory comprising a plurality of rows and columns of memory cells, each column of cells associated with a conductive bitline. The memory further includes precharge circuitry for precharging a selected one of the bitlines in response to a received control bit.

US Patent No. 6,779,076 discloses a DRAM wherein the execution of a command to perform a refresh operation on a set of memory cells is replaced by the execution of a substitute command to perform a read or write operation if such a substitute command is received. The DRAM includes a refresh controller that periodically refreshes the DRAM on a row-by-row basis, and a command decoder that causes the refresh to be aborted in the event a read or a write command is received by the DRAM during a refresh. The refresh is aborted by saving the data stored in the row being refreshed in the secondary sense amplifiers and then isolating the sense amplifiers from the array. The memory access is then implemented in a normal manner. Since the DRAM can be accessed without waiting for the completion of a refresh in progress, the DRAM can be used as a cache memory in a computer system.

The invention is defined by claims 1 and 8.

### BRIEF DESCRIPTION OF THE DRAWINGS

Embodiments of the disclosure will be readily understood by the following detailed description in conjunction with the accompanying drawings. Embodiments of the disclosure are illustrated by way of example and not by way of limitation in the figures of the accompanying drawings.
**Figures 1a-1h** show schematics of example DRAM memory cell configurations as are known in the art;
**Figures 2a-2c** show various example core memory cell-matrix organizations and physical layouts in accordance with the prior art;
**Figure 3** shows a typical memory matrix architecture including memory cell details in accordance with the prior art;
**Figure 4** shows a flow chart depicting digital memory operation in accordance with embodiments of the present invention;
**Figure 5** shows a block diagram of a memory matrix array architecture in accordance with various embodiments of the present invention;
**Figure 6** shows a schematic of a memory cell architecture in accordance with embodiments of the present invention;
**Figure 7** shows a memory matrix architecture including a precharge select line in accordance with embodiments;
**Figure 8** shows a memory matrix architecture including a precharge select line and a precharge voltage line in accordance with embodiments;
**Figure 9** shows a flow chart depicting digital memory operation in accordance with various embodiments of the present invention in which one command may be substituted for another without having to initiate a new access cycle;
**Figures 10-21** depict timing diagrams of DRAM chips in the prior art;
**Figures 22-28** show improvements over a traditional DDR SDRAM (Synchronous double data rate) DRAM in accordance with various embodiments of the present invention; and
**Figure 29** illustrates an example computer system suitable for use to practice various embodiments of the present invention.

### DETAILED DESCRIPTION

In the following detailed description, reference is made to the accompanying drawings which form a part hereof, and in which is shown by way of illustration embodiments of the disclosure. It is to be understood that other embodiments may be utilized and structural or logical changes may be made without departing from the scope of the disclosure. Therefore, the following detailed description is not to be taken in a limiting sense, and the scope of embodiments in accordance with the disclosure is defined by the appended claims and their equivalents.

Various operations may be described as multiple discrete operations in turn, in a manner that may be helpful in understanding various embodiments; however, the order of description should not be construed to imply that these operations are order dependent.

The description may use perspective-based descriptions such as up/down, back/front, and top/bottom. Such descriptions are merely used to facilitate the discussion and are not intended to restrict the application of the embodiments.

The terms "coupled" and "connected," along with their derivatives, may be used. It should be understood that these terms are not intended as synonyms for each other. Rather, in particular embodiments, "connected" may be used to indicate that two or more elements are in direct physical or electrical contact with each other. "Coupled" may mean that two or more elements are in direct physical or electrical contact. However, "coupled" may also mean that two or more elements are not in direct contact with each other, but yet still cooperate or interact with each other.

For the purposes of the description, a phrase in the form "A/B" means A or B. For the purposes of the description, a phrase in the form "A and/or B" means "(A), (B), or (A and B)." For the purposes of the description, a phrase in the form "at least one of A, B, and C" means "(A), (B), (C), (A and B), (A and C), (B and C), or (A, B and C)." For the purposes of the description, a phrase in the form "(A)B" means "(B) or (AB)," that is, A is an optional element.

The description may use the phrases, "various embodiments," "in an embodiment," or "in embodiments," which may each refer to one or more of the same or different embodiments. Furthermore, the terms "comprising," "including," "having," and the like, as used with respect to embodiments as described in the present disclosure, are synonymous.

Embodiments of the invention described here may relate to READ and WRITE memories in all forms such as, for example, DRAM, SRAM, flash EEPROM, etc. In current memory architectures, the ACCESS cycle and the PRECHARGE cycle are performed separately. Upon receiving an ACCESS command (such as, for example, a READ or WRITE), a typical memory chip or device may assume that all bit lines in the chip are precharged and are ready to be accessed. To accomplish this, after each ACCESS cycle, all bit lines are precharged in anticipation of the next ACCESS cycle. This may use more power than is necessary for a number of reasons. The first is that in the best-case scenario, only 32 bits may be read from a typical memory device at one time, yet many more bit lines are precharged, thereby consuming unnecessary power. Secondly, in many cases, memory cells must occasionally be REFRESHED because memory cells tend to lose their stored charge due to leakage. The REFRESH operation ensures that the storage elements of the memory cells are renewed periodically to prevent memory loss. However, when memory cells are REFRESHED, they must be first precharged. Thus, in a typical architecture, bit lines are precharged twice before each refresh. Once after the most recent ACCESS cycle as described above, then again prior to the refresh operation.

In order to meet the growing demands placed on digital memory devices, a need has arisen to architect memories in a three-dimensional addressing manner, instead of the traditional 'row x column' two-dimensional matrix addressing approach.

Embodiments of the present invention may selectively precharge a subset of bit lines rather than all bit lines as in the prior art. At the same time, embodiments of the present invention may allow for random row access in contrast to prior art schemes such as round-robin.

The present invention, in embodiments, may use a received memory address, or identifier, to not only access the memory cells as in the prior art, but also to select the bit lines to be precharged prior to the access. In this way, precharge time may be reduced and power consumed may be limited during the PRECHARGE cycle. Additionally, the PRECHARGE and the ACCESS cycle may, in embodiments, occur simultaneously or substantially simultaneously.

Also, in prior art implementations, all sense amplifiers - which may be used to facilitate the memory cell in driving the bit line voltage during the ACCESS cycle - are enabled. This is also potentially wasteful in terms of power. Embodiments of the present invention, therefore, may enable only a portion of all sense amplifiers during an ACCESS cycle in order to conserve power consumed during the ACCESS cycle and/or reduce ACCESS cycle time.

In the prior art, Multibank DRAM'S routinely precharge ALL banks - however, only one bank can be accessed at a time in the next ACCESS cycle (which could be one clock or several clocks). If one has 'a priori' knowledge of incoming address stream - as is the case in numerous communication applications of cell and packet switching - this invention can significantly reduce operating power by preparing the selective bank for DATA WRITE. Similarly, if the EGRESS pattern is known for OUTPUTTING packets, only that bank (or banks) needing to be precharged can be precharged prior to reading data. Moreover, almost 50% of operating power is consumed by the memory banks' operation; the remaining power is consumed in the periphery that operates the banks. Thus, reducing the operating power of the memory banks may significantly reduce the overall power consumed by the memory. Precharging of a subarray only, for example, consumes less power and is much faster than is achieved in the prior art.

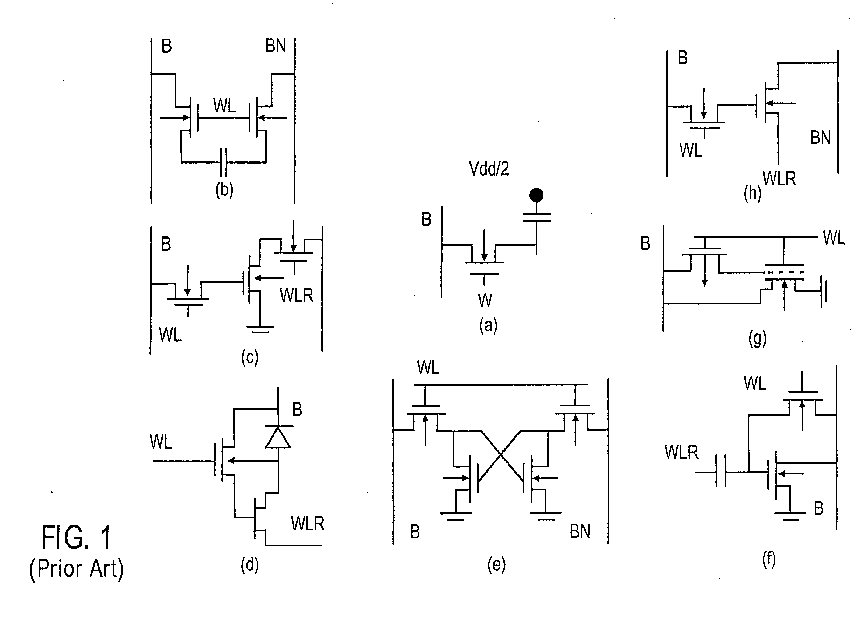

**Figures 1a through 1 h** depict various schematics of example DRAM memory cell configurations as are known in the art. Various embodiments of the present invention may be utilized to reduce consumption of power during the PRECHARGE cycle and maintain a low random row access latency time in memory chips comprising these and other known or unknown memory cell configurations including memory types other than DRAM.

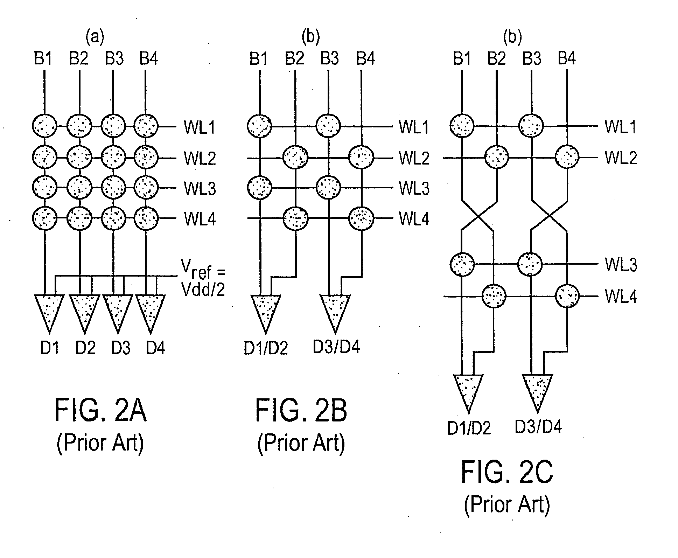

**Figures 2a-2c** show various example DRAM core memory cell-matrix organizations and physical layouts in accordance with the prior art. Figure 2a shows a conventional crosspoint array layout. Figure 2b shows a folded bit line array layout. Figure 2c shows a folded twisted bit line architecture. Various embodiments of the present invention may be utilized to reduce consumption of power during the PRECHARGE cycle and maintain a low random row access latency time in memory chips comprising these and other known or unknown core memory organizations including memory types other than DRAM.

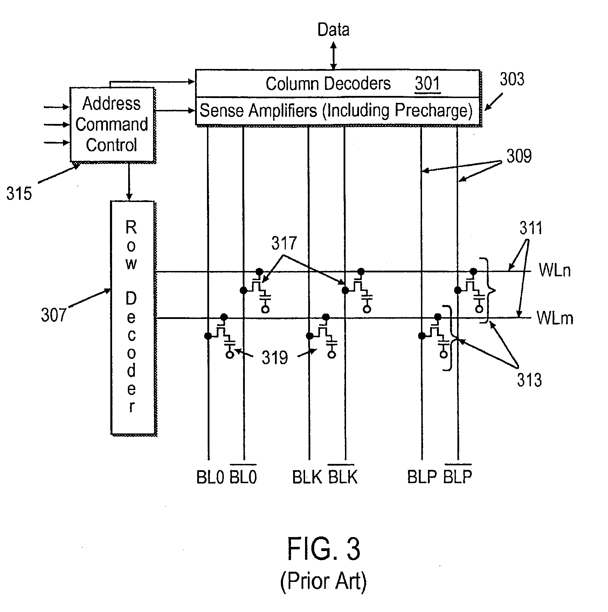

**Figure 3** shows a typical memory matrix architecture including memory cell details in accordance with the prior art. Address command control circuit **315** may receive a command to perform an access operation on certain memory cells **313.** Address command control circuit may also receive a memory address or identifier which may include a row address and/or a column address identifying the memory cells to be accessed. Address command control circuit **315** may pass the identifier and/or the column address to column decoders **301.** Column decoders **301** may decode the identifier and/or the column address to determine which columns of memory cells include the particular memory cells to be accessed. Address command control circuit **315** may also pass to row decoder **307** the identifier and/or row address. Row decoder **307** may decode the identifier and/or row address to determine which row of memory cells contains memory cells to be accessed. If the received command operation is a READ operation, the following events may occur. The prior art circuit will assume that all bit lines **311** have been precharged (see below). Typically, bit lines **309** will be precharged to a voltage level one half of the reference voltage level (V_{CC}/2) although other precharge voltages are possible. Row decoder **307** will set or fix an access voltage on the row line **311** containing memory cells to be accessed. Each memory cell **313** depicted in figure 3 is shown with a typical memory cell configuration of one gating transistor **317** and one storage element capacitor **319.** Across capacitor **319** may be a storage voltage indicating either a binary "1" or a binary "0". The voltage levels used to represent binary "1" and a binary "0" may vary with implementations and/or configurations. Although memory cell **313** depicts the most common type of memory cell configuration, many others are known (see figures 1a-1h). When an associated terminal of gating transistor **317** connected to a row line **311** detects that the access line voltage has been set or fixed by row decoder **307,** this detected voltage may open up gating transistor **317** and allow storage element **319** to share its stored voltage with an associated bit line **309.** This sharing may cause a small perturbation in the voltage level of the bit line. Sense amplifier circuit **303** (which may contain multiple sense amplifiers) may facilitate the driving of the stored voltage level by applying positive feedback to the small perturbation until the bit line is set or fixed to the stored voltage level. Because row decoder **307** may set or fix only one row line **311** to an access voltage level, only one row of memory cells **313** may be switched "on" to drive the voltage level of bit lines **309.** This is sometimes referred to as opening a page. At this point, the voltage levels of bit lines **309** may be read by sense amplifiers **303** and the output sent to an output pin of the memory chip (not shown). Also, this operation may deplete the charge across storage element **319;** however the operation of sense amplifiers **303** may refresh the stored voltage of storage element **319.**
   If the received command operation is a WRITE command, row decoder **307** may set or fix an access voltage on a row line as in a READ operation. Next, sense amplifiers **303** may drive voltages on bit lines **309** to the desired voltages (representing the desired binary logic values to be written) which may, in turn, drive the voltages of the various storage elements **319** to the desired voltage levels.
   Additionally, address command control circuit **315** may signal to sense amplifier **303,** which may include a precharge circuit, to precharge all bit lines **309** in the circuit. All bit lines **309** in the device may be precharged in response. Typically, this precharge cycle occurs after the access cycle in preparation for the next immediate access command. Also, occasionally, all bit lines will be refreshed following similar procedures as is known in the art and is well known.
   In prior art embodiments, such as those depicted in figure 3, selecting one of word lines **311** connected to memory cells **313** "turns on" all memory cells **313** connected to the selected row line **311** as described above. Thus, all memory cells **313** are switched "on" despite the fact that not all memory cells **313** may be subsequently read in a current access cycle. By activating all memory cells **313** attached to a single row line **311,** all of those memory cells **313** connected to the selected row line **311** may be interrogated during the current access cycle and may need to be replenished by the action of sense amplifiers **303** as described above and may not be subsequently accessed (READ, WRITE, or other operation) without first allowing the storage levels to refresh. This adds latency to any subsequent access operations. This also increases the potential for a "soft error' to occur in unread but activated memory cells **313.**

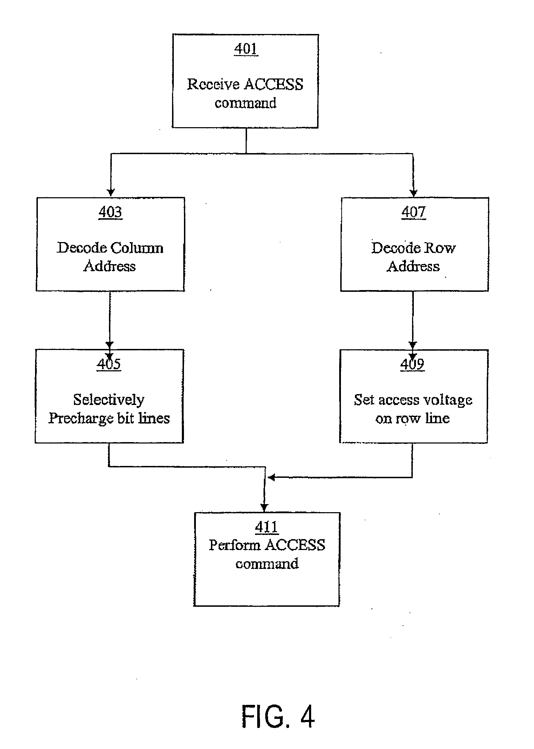

**Figure 4** shows a flow chart depicting digital memory operation in accordance with various embodiments of the present invention. At **401,** an access command such as a READ or WRITE for example may be received by a digital memory device and a memory address or identifier may be provided on address pins of the digital memory device. In embodiments, the memory address may comprise a row address and a column address identifying the row and column(s) of the memory cells to be accessed. In embodiments, the row address and the column address may each be separately applied to the input pins of the memory device on different clock cycles. In embodiments, the row address may be presented first. In embodiments, the column address may be presented first. At **403,** a column decoder of the digital memory device may demultiplex or decode the column address of the memory cells to be accessed. At **405,** a selective precharge circuit may selectively precharge a set of bit lines including those bit lines that contain the memory cells to be accessed. In embodiments, the selective precharge may be of fewer bit lines than all of the bit lines in a memory bank or an entire chip. In embodiments, the set of bit lines may include only those bit lines connected to memory cells to be accessed. In embodiments, the set of bit lines selectively precharged may be a bank of memory cells, a minibank, a subbank, an array of memory cells, a sub-array of memory cells, an 8-byte word (octet), 2 columns in a word line, or a single memory cell.
   At **407** a row decoder may demultiplex or decode a row address of the memory cells to be accessed. At **409,** in response, the row decoder may set or fix a access voltage on a row line connected to the row with memory cells to be accessed. Once the bit lines have been selectively precharged and the access voltage has been set or fixed on the appropriate row with memory cells to be accessed, sense amplifiers may facilitate the performing of the access operation at **411** and the data bits may be read and sent to an output bus (if the access operation is a READ operation, for example).
   Thus, as soon as the column addresses are presented - either in a broad non-multiplexed or multiplexed addressing system - the precharge may be executed prior to data access. The row address chain may proceed up to row line (e.g. page line or word line) coding completion, but may not activate the row line until precharge is completed. In embodiments, this may reduce row cycle time T_{RC}. In current DRAM architectures and layouts, for example, precharge time may be nearly 50% of T_{RC}. However, selectively precharging only a fraction of all bit lines may, in embodiments, reduce precharge time to between 5-10% of T_{RC}.
   Embodiments of the present invention may apply not just to DRAM, but any memory which requires a bit line precharge including, for example, FeRAM and SRAM memory architectures of many types.

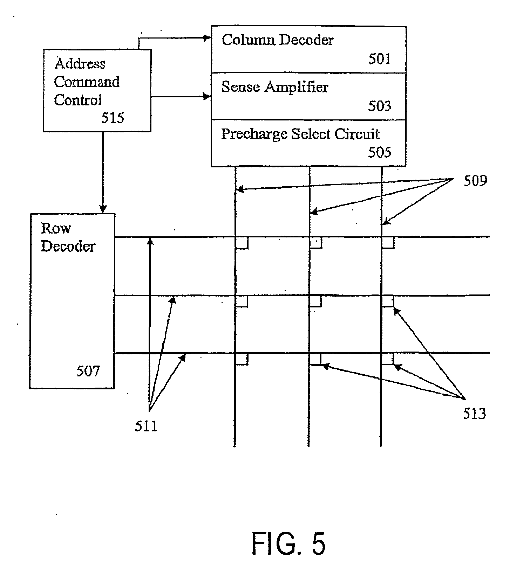

**Figure 5** shows a block diagram of memory matrix array architecture in accordance with various embodiments of the present invention. Address command control circuit **515** may receive a command to perform an access operation on certain memory cells **513.** Address command control circuit may also receive a memory address or identifier which may include a row address and/or a column address identifying those of memory cells **513** to be accessed. In embodiments, the row address and the column address may be each separately applied to the input pins (not shown) of the memory device on different clock cycles. In embodiments, the row address may be presented first. In embodiments, the column address may be presented first. Address command control circuit **515** may pass the column address to column decoder **501.** Column decoder **501** may decode or multiplex the column address to determine which columns of memory cells **513** include the particular memory cells to be accessed. Address command control circuit **515** may also pass to row decoder **507** the row address which may then determine which row of memory cells **515** contains memory cells to be accessed.
   If the received command operation is a READ operation, the following events may occur in embodiments. Unlike in the prior art circuit, the circuit may not assume that all bit lines **509** have been precharged. Precharge select circuit **505** may receive either from column decoder **501** or address command control circuit **515** signals indicating which of bit lines **509** to selectively precharge. In embodiments, precharge select circuit **505** may contain precharge select transistors (not shown) to allow it to selectively precharge the appropriate bit lines **509.** In embodiments, precharge select circuit **505** may be part of sense amplifier circuit **503** which may contain multiple sense amplifiers. In embodiments, sense amplifiers **503** may contain a plurality of sense amplifiers each associated with each of the plurality of bit lines **509.**
   In embodiments, the selective precharge may be of fewer bit lines **509** than all of the bit lines in the memory bank or chip. In embodiments, the set of bit lines **509** may include only those bit lines **509** connected to those of memory cells **513 to** be accessed. In embodiments, the set of bit lines **509** selectively precharged may be a bank of memory cells, an array or grid of memory cells, a sub-array of memory cells, an 8-byte word (octet), 2 columns in a word line, or a single memory cell **513** among others. For those of bit lines **509** to be selectively precharged, precharge select circuit **505** may set or fix a voltage level approximately equal to one half of the reference voltage level (V_{CC}/2) or some other voltage.
   Row decoder **507** may set or fix an access voltage on row line **511** containing memory cells **513** to be accessed. When a memory cell **513** detects that the access line voltage has been set or fixed, it may allow a storage element (not shown) of memory cell **513** to share its stored voltage with an associated bit line **509.** This sharing may cause a small perturbation in the voltage level of bit line **509.** Sense amplifier circuit **503** may facilitate the driving of the stored voltage level by applying positive feedback until bit line **509** is driven or set or fix to the stored voltage level. Because row decoder **507** may only set or fix one row line **511** to the access voltage level, only one row of memory cells **513** may be switched "on" and drive the voltage level of bit lines **511.** At this point, the voltage levels of bit lines **509** may be read by sense amplifier circuit **503** and the output sent to an output data bus (not shown). Also, this operation may deplete the charge stored within memory cell **513;** however the operation of sense amplifier circuit **503** may refresh the stored voltage.
   If the command operation is a WRITE command, row decoder **507** may set or fix an access voltage on one of row lines **511** as in a READ operation. Next, sense amplifier circuit **503** may drive voltages on bit lines **509** to the desired voltage (representing the desired binary logic value) which may, in turn, drive the voltage of memory cell **513** to the desired voltage level. Also, occasionally, all bit lines **509** may be refreshed following similar procedures as described above (where bit lines are precharged, values are read, then rewritten or refreshed by operation of sense amplifiers **503).**

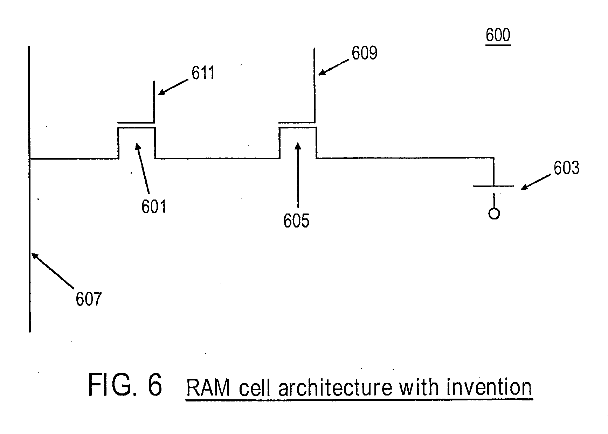

**Figure 6** depicts a schematic of memory cell architecture in accordance with various embodiments of the present invention. Memory cell **600** may include a gating transistor **601** with a terminal operatively coupled to a row decoder (not shown) via row line **611** (also called a word line). Another terminal of gating transistor **601** may be operatively coupled to a sense amplifier (not shown) and a column decoder (not shown) via bit line **607.** Memory cell **600** may also include a capacitor **603** which may act as a storage element for memory cell **600.** Capacitor **603** may store a stored voltage representing a logical binary bit "0" or a logical binary bit "1". The actual storage voltage level, or range of voltage levels, representing a "0" or a "1" may vary between memory cell architectures; embodiments of the present invention are not limited to any one set of stored voltage levels or ranges.
   Memory cell **600** may also include precharge select transistor **605** which may be positioned between gating transistor **601** and capacitor **603.** A terminal of precharge select transistor **605** may be operatively coupled to a precharge select circuit (not shown) via precharge select line **609.** In embodiments, the precharge select circuit may set or fix a precharge select voltage on precharge select line **609** which may cause bit line **607** to be driven to a precharge voltage level. Thus, by inclusion of precharge select transistor in memory cell **600** only those specific columns with memory cells to be accessed may be precharged, thus saving power consumed during precharge cycles. These embodiments represent a very fine granularity with which bit lines may be selectively precharged: only those specific bit lines connected to memory cells to be accessed may be precharged. In alternative embodiments (not shown) this same level of fine granularity may be achieved by, for example, placing similar precharge select transistors in the precharge select circuit. In other embodiments, a fewer number of precharge select transistors may be used and the selective precharging of bit lines may be accomplished with less granularity resulting in more bit lines than may be necessary being precharged, but still less than all bit lines thus resulting in power savings. In these embodiments, power savings may be in part a function of the granularity with which bit lines are precharged.
   In embodiments utilizing memory cells, such as for example DRAM memory cells, with transistors in vertical dimensions, the die size increase or penalty for the inclusion of a precharge select transistor may be minimal.

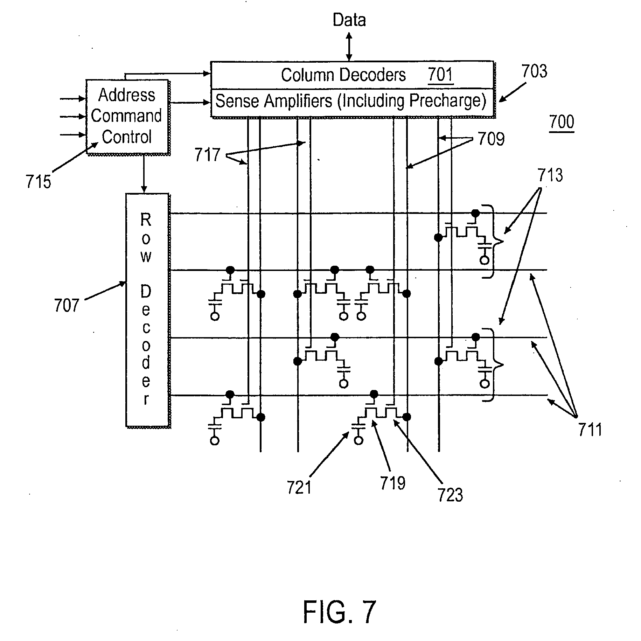

**Figure 7** shows a memory matrix or grid architecture including a precharge select line achieving column-level granularity in selective precharging in accordance with various embodiments. Memory cells 713 may be, in embodiments, arranged substantially in a grid or a matrix with multiple columns and multiple rows. Each memory cell 713 may form a part of exactly one row and exactly one column of the grid. Each memory cell 713 in a single column may be connected to all other memory cells 713 in the same column by a corresponding bit line 709 and each memory cell 713 in a row may be connected to all other memory cells 713 in the row by a corresponding row line 711. Address command control circuit **715** may receive a command to perform an access operation on certain ones of memory cells **713.** Address command control circuit **715** may also receive a memory address or identifier which may include a row address and/or a column address identifying those of memory cells **713** to be accessed. In embodiments, the row address and the column address may be each separately applied to the input pins of the memory device (not shown) on different clock cycles. In embodiments, the row address may be presented first. In embodiments, the column address may be presented first. Address command control circuit **715** may pass the column address to column decoder **701.** Column decoder **701** may decode or multiplex the column address to determine which columns of memory cells **713** include the particular memory cells to be accessed. Address command control circuit **715** may also pass to row decoder **707** the row address which may then determine which row of memory cells **713** contains memory cells to be accessed.
   If the received command operation is a READ operation, the following events may occur in embodiments. Unlike in prior art circuits, the circuit may not assume that all bit lines **709** have been precharged. A precharge select circuit **705,** which may be part of sense amplifier circuit **703,** may receive either from column decoder **701** or address command control circuit **715** signals indicating which columns of memory cells **713** to selectively precharge. In embodiments, a sense amplifier circuit **703** may also contain a plurality of sense amplifiers.
   Each of memory cells **713** may comprise a gating transistor **719,** storage capacitor **721,** and precharge select transistor **723.** In embodiments, each precharge select transistor **723** may be operatively coupled to the precharge circuit via the plurality of precharge select lines **717.** The precharge select circuit may set or fix a precharge select voltage on each precharge select line **717** thereby facilitating the selective precharging of the plurality of bit lines **709.** In embodiments, only those columns containing memory cells to be accessed may be precharged, thus achieving a fine granularity.
   Row decoder **707** may set or fix an access voltage on one of row lines **711** containing memory cells to be accessed. When one of memory cells **713** detects that the access line voltage has been set or fixed by row decoder **707,** this may open up gating transistor **719** and allow storage capacitor **721** to share its stored voltage with an associated bit line **709.** This sharing may cause a small perturbation in the voltage level of bit line **709.** Sense amplifier circuit **703** may facilitate the driving of the stored voltage level by applying positive feedback to the small perturbation until bit line **709** is set or fixed to the stored voltage level. Because row decoder **707** may only set or fix one row line **711** to a access voltage level, only one row of memory cells **713** may be switched "on" and drive the voltage level of bit lines **709.** At this point, the voltage levels of bit lines **709** may be read by sense amplifier circuit **703** and the output sent to an output data bus (not shown). Also, this operation may deplete the charge across storage capacitor **721;** however the operation of sense amplifier circuit **703** may refresh the stored voltage.
   If the command operation is a WRITE command, row decoder **707** may set or fix an access voltage on row lines **711** as in a READ operation. Next, sense amplifier circuit **703** may drive voltages on bit lines **709** to the desired voltage (representing the desired binary logic values to be stored) which may, in turn, drive the voltage of storage capacitors **721** to the desired voltage levels. Also, occasionally, the stored voltages on storage capacitors **721** may be refreshed following similar procedures as described above.
   In embodiments of the present invention utilizing precharge select transistors **723** in series between gating transistors **719** and storage capacitors **721,** storage voltage levels of storage capacitors **721** may remain isolated from bit lines **709** even when gating transistors **719** are activated. This is because only precharge select transistors **723** connected to memory cells that are to be accessed may be activated during a current access operation. All other precharge select transistors **723** may remain inactivated. Thus, precharge select transistors **723** may allow a memory cell **713** to be maintained in an "off" mode even when its gating transistor **719** is activated by the setting or fixing of a row line voltage on row line **711.** In this way, utilizing precharge select transistors **723** may allow a level of decoding at the memory cell level (i.e. the "bit" level). Individual memory cells **713** may be activated at one time, rather than an entire row of memory cells at one time as with the prior art. This decoding may be accomplished, in embodiments, by applying a precharge select voltage level to precharge select lines **717** at the time, or shortly after, precharge select circuit **705** selectively precharges corresponding bit lines **709** connected to the same column of memory cells **713.** Thus, precharge select circuit **705** may, in embodiments, handle this additional level of decoding.
   As described above, a first memory cell **713** on row line **711** may be selected and a READ, WRITE, or other operation may be performed on the first memory cell **713** by setting or fixing the row line select voltage, precharging required bit lines **709,** and switching on sense amplifier circuit **703.** Next - by the addition of an additional level of decoding as described above - within a very short period of time and within the same ACTIVE cycle, a second bit/memory cell **713** on the same selected row line **711** may be "turned on" and a READ, WRITE, or other operation performed on that second bit/memory cell **713** without needing to progress to the next access cycle. Additionally, bit lines **709** that are connected to the second bit/memory cell **713** may be precharged while the first bit/memory cell **713** is being accessed. By isolating the second bit/memory cell **713** while the first bit/memory cell **713** is being accessed (using the additional level of decoding described above), the storage voltage of the second bit/memory cell **713** may be preserved and may not need to be refreshed subsequent to performing an access operation on the first bit/memory cell **713.** As described above in reference to Figure 3, prior art configurations cause the storage voltage levels of all memory cells connected to a row line to be depleted, even when those memory cells are not accessed during a current access operation. Before those bits may be accessed, it may be necessary to refresh those memory cells and initiate a new access cycle increasing latency. However, in embodiments of the present invention, a burst mode operation may be supported whereby multiple bits in a single row may be selectively precharged and accessed subsequently to one another in a very short period of time, without entering a new access cycle, with a reduced chance of soft errors, and/or with reduced power consumption.

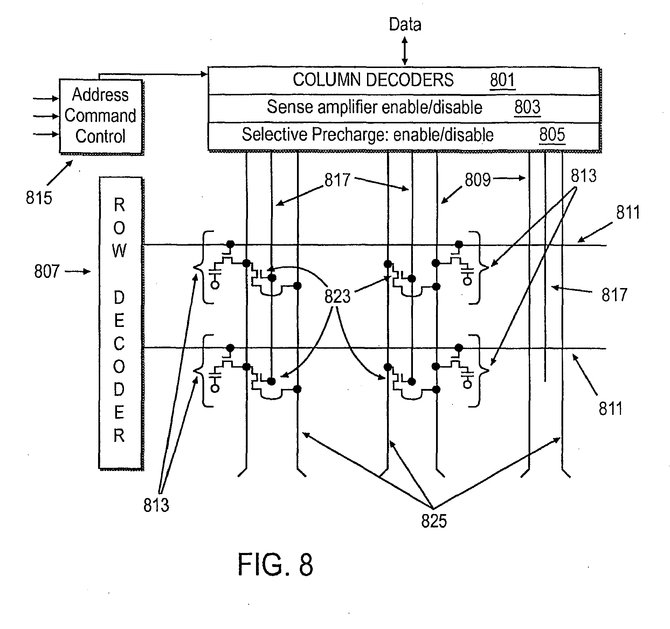

**Figure 8** shows a memory matrix architecture including a precharge select line **817** and a precharge voltage line **825** in accordance with various embodiments of the present invention. The memory matrix of Figure 8 operates in a similar manner as the memory matrix of Figure 7. However, differences are highlighted below.
   Each of memory cells **813** contains a gating transistor and a storage capacitor (not labeled). Precharge select transistors **823** are placed adjacent to each of memory cells **813** and are operatively coupled to precharge select circuit **805** via precharge select lines **817.** Precharge select transistor **823** is also operatively coupled to precharge select circuit **805** via precharge voltage line **825.** Upon the setting or fixing of a precharge select voltage on precharge select line **817,** precharge select transistor may facilitate the driving of bit lines **809** to the precharge select voltage set or fixed on precharge voltage lines **825.** In this way, the plurality of bit lines **809** may be precharged to the precharge voltage using precharge select transistors **823.** Only those columns containing memory cells to be access may, in embodiments, be precharged. In embodiments, more than all columns containing memory cells to be access, but not all columns may be precharged using the memory matrix architecture depicted in figure 8. In embodiments, the matrix architecture depicted in Figure 8 may cause a small die size penalty, but may also result in substantial savings in operational power with little or no sacrifice in performance.

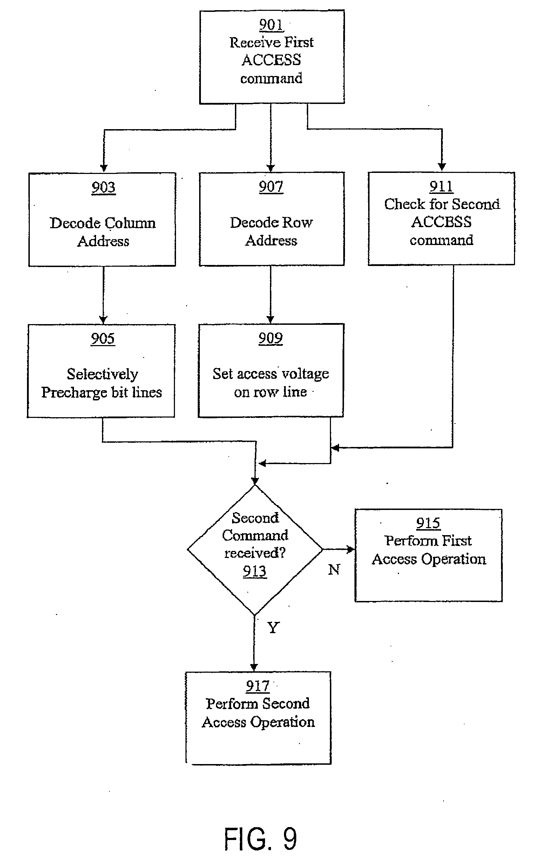

**Figure 9** shows a flow chart depicting digital memory operation in accordance with various embodiments of the present invention in which one command may be substituted for another without requiring a new access cycle. At **901,** a.first access command, such as a READ or WRITE for example, may be received by a digital memory device and a memory address or identifier may be provided on address pins of the digital memory device. In embodiments, the memory address may comprise a row address and/or a column address identifying the row and column(s) containing memory cells to be accessed. In embodiments, the row address and the column address may each be separately applied to input pins of the memory device on different clock cycles. In embodiments, the row address may be presented first. In embodiments, the column address may be presented first. At **903,** a column decoder of the digital memory device may demultiplex or decode the column address of the memory cells to be accessed. At **905**, a selective precharge circuit may selectively precharge a set of bit lines including those bit lines that contain memory cells to be accessed. In embodiments, the selective precharge may be of fewer bit lines than all of the bit lines in a memory bank or an entire chip. In embodiments, the set of bit lines may include only those bit lines connected to memory cells to be accessed. In embodiments, the set of bit lines selectively precharged may be a bank of memory cells, an array or grid of memory cells, a sub-array of memory cells, an 8-byte word (octet), 2 columns in a word line, or a single memory cell among others.
   At **907** a row decoder may demultiplex or decode a row address of the memory cells to be accessed. At **909,** in response, the row decoder may set or fix a access voltage on a row line connected to the row with memory cells to be accessed. At **911,** the digital memory device may be adapted to sense a second ACCESS command. For example, if the first command was a READ, the second command may, in embodiments, be a WRITE or other command. In embodiments, if the first command is a WRITE, the second command may be a READ command or other command. Once the bit lines have been selectively precharged, the access voltage has been set or fixed on the appropriate row with memory cells to be accessed, and if no new ACCESS command has been detected at **913** sense amplifiers may facilitate the performing of the first access operation at **915** and the data bits may be read and sent to an output bus (if the access operation is a READ operation, for example). If a new ACCESS command has been detected at **913,** then sense amplifiers may facilitate the performing of the second access operation at **917.**
   The operations depicted in Figure 9 may be made possible by, for example, initiating the PRECHARGE cycle at the beginning of the ACCESS cycle (on the front end) rather than initiating it after (on the back end). Thus, when a memory address including a bank and row address are presented or a flat address where row and column addresses are received, the particular bank, minibank, subbank, or subarray may be precharged and then activated for access. Until this time, a bank or part of a bank may not be precharged. Thus, precharge may be an integral part of the active command at the front end of operation of memory access and not at the back end as is done in the prior art.
   Thus, while the memory chip is waiting for the bit lines to be selectively precharged at **905,** and the row decoder is decoding the row address at **907,** a new ACCESS command can be received on the appropriate pin of the memory chip. This could be useful when, for example, a memory controller wants to reprioritize between a READ, WRITE, or REFRESH. In the prior art, if one wanted to abort a WRITE, for example and start a READ, a new cycle had to begin all over again. In embodiments of the present invention, the chip can abort one operation at one clock cycle and issue a new operation at another clock cycle without any loss of data integrity. This may be useful in, for example, communication-oriented memories, where the ingress pattern may be known, but not the egress.
   In embodiments, because the precharge may be at the beginning of the cycle, the data access may have to be delayed compared to a traditional memory chip or DRAM if a whole bank is to be selectively precharged. This may result in a one time "startup" penalty if the banks are continuously accessed on every clock cycle. Instead of, for example 4 to 6 cycles for a prior art memory chip to receive a first access command and put data on an output bus (for example as in a READ operation), embodiments of the present invention may require, for example, 7 to 9 cycles under a worst case scenario. In embodiments where the memory architecture is a subarray type architecture where the subarray is only 64kbits or 128kbits, the selective precharge may only take one system clock and thus the penalty may be much smaller. However, even in embodiments when there is a "startup" penalty, the bank random access time remains unchanged. In embodiments using a bit burst length of 8, for example, the data access penalty may be inconsequential for overall performance.
   In embodiments of the present invention, a "user" may be able to control precharge operation selectively via pins or pads of a memory device. A PRECHARGE command may be presented to the device along with a memory address of a specific location - a bank, subarray or even one row similar to a READ or WRITE operation. In embodiments, a whole device could also be precharged if so desired. In embodiments, a user could program the memory device to selectively precharge at the beginning or at the end of an operation using a MODE REGISTER configuration command. By executing in this fashion, significant reductions in operating power may be achievable with maximum data throughput and no performance degradation in any aspect.
   Embodiments of the present invention may intentionally avoid precharging any or all banks after a READ or WRITE operation or access. In these embodiments, operating power may be conserved in yet another way. Many types of memory chips need to be refreshed periodically to avoid leakage. At the beginning of each refresh cycle, all columns to be refreshed must be precharged. However, when precharge occurs at the end of an ACCESS cycle, the columns to be refreshed must be precharged again at the beginning of the refresh cycle which uses energy unnecessarily. In embodiments that avoid precharging at the end of each ACCESS cycle, when the next cycle for a particular bank is a refresh cycle, the memory device may avoid precharging twice, thereby conserving energy in embodiments. Abandoning precharge in the prior ACCESS cycle may have no performance consequence since all refresh cycles have a precharge at the beginning of the cycle anyway. Also, refresh may have no data ACCESS; therefore there may be no access delay penalty, or in embodiments, an inconsequential one. In embodiments, precharge select may be disabled during a refresh cycle to allow all bit lines to be precharged.
   In embodiments utilizing a separate I/O configuration, data may be READ or WRITTEN into banks on successive cycles without violating burst length requirements no matter which selective precharge mode is implemented.
   In embodiments, selective precharge may allow flexibility to select a bank sequence. For example, in a prior art 8-bank RLDRAM, all banks must be cycled through in a particular order. If one were to jump from one bank to another without following the proper sequence, the bank may not be ready for activation. However, embodiments of the present invention implementing selective precharge may allow for a selective precharge of a desired bank at the beginning of the ACTIVE operation and access of that desired bank without following any particular bank order.
   In embodiments of the present invention, only those sense amplifiers associated with the selectively precharged columns may be enabled. Thus, this may save operational power not only on the PRECHARGE cycle as described previously, but also on the access cycle. This may not cause performance to suffer because there may be no reason for other sense amplifiers to operate. This may be accomplished through proper column address decoding, in embodiments. Thus, in embodiments utilizing both selective precharge of bit lines and selective activation of associated sense amplifiers, the junction and case temperature of the integrated circuit may be reduced which may enhance refresh periods as well as long term reliability of the integrated circuit.
   Another benefit of the present invention may be to reduce the soft errors and transient errors related to bit line cycle time. Because only a few bit lines may be selectively precharged on any given access cycle, these unwanted errors may be reduced.

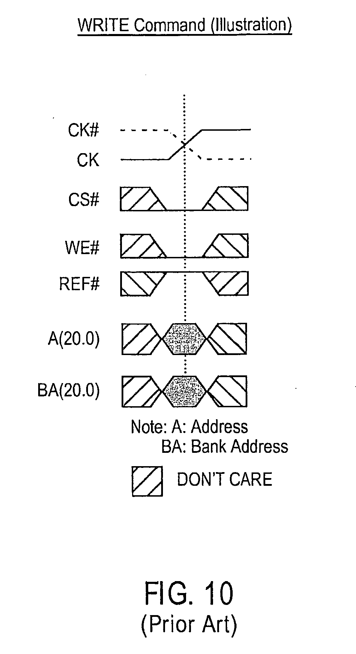

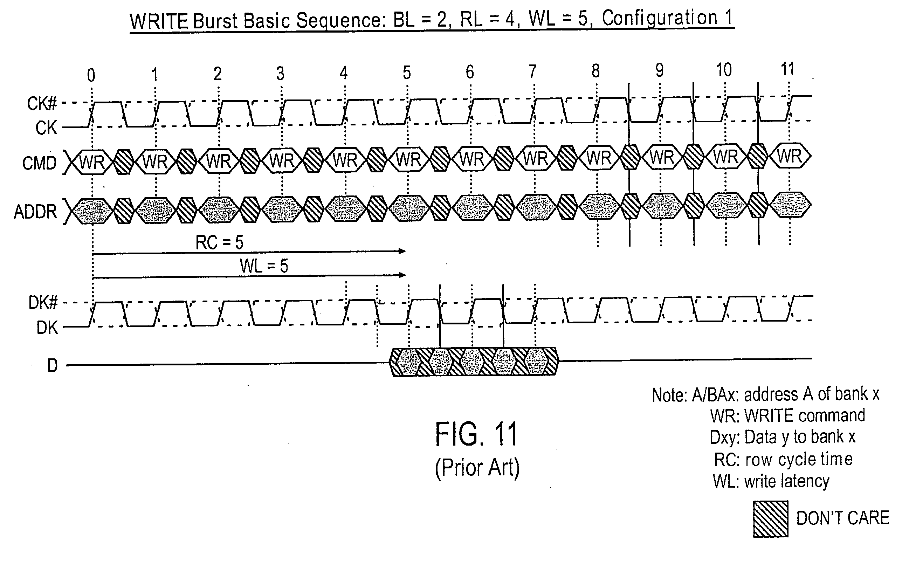

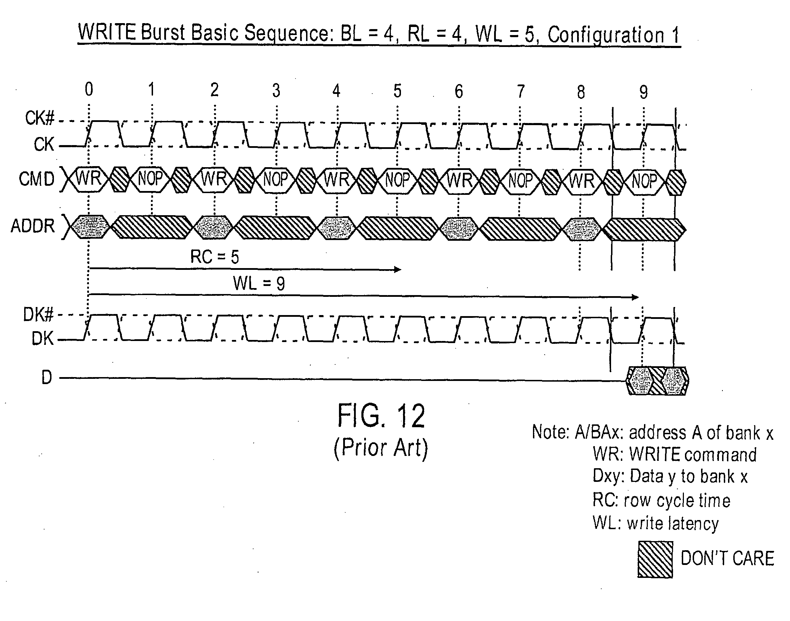

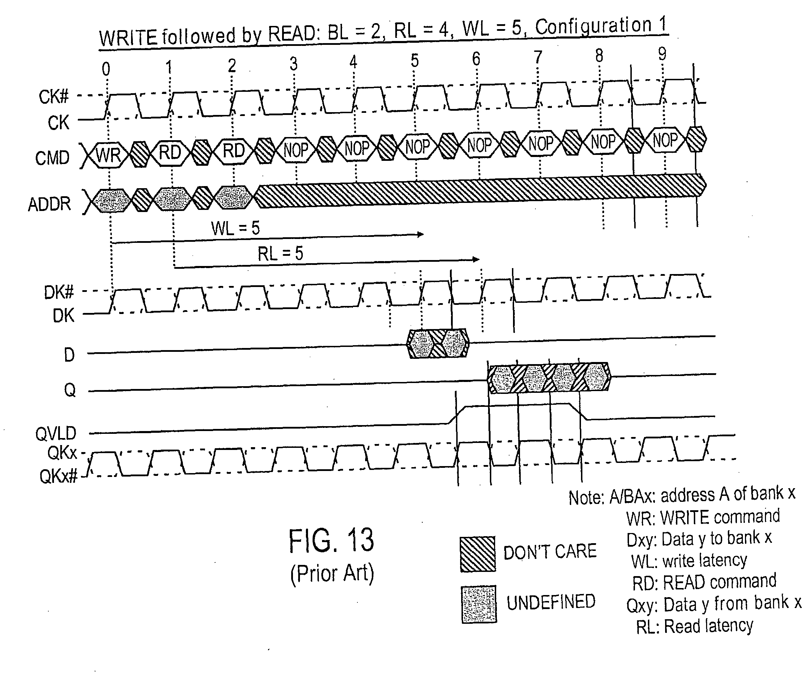

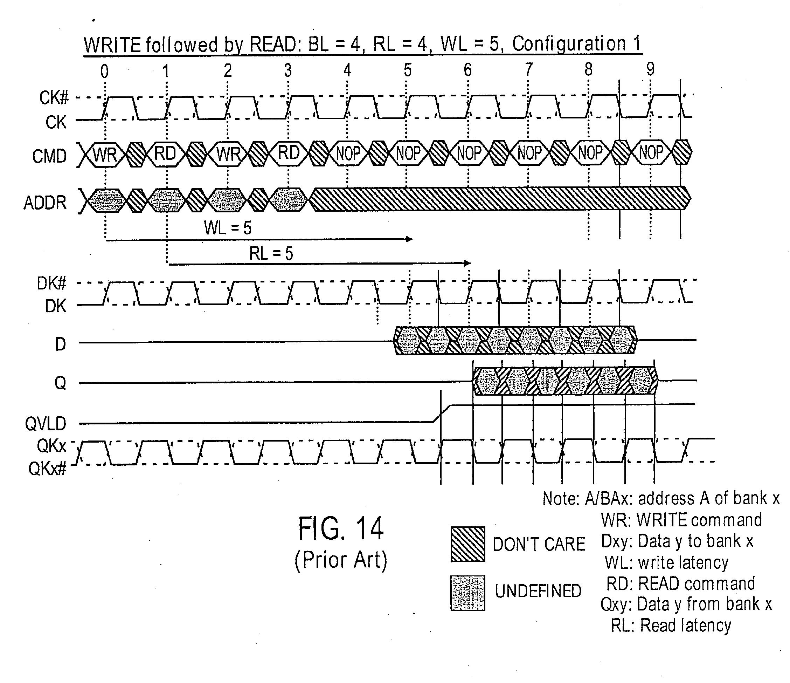

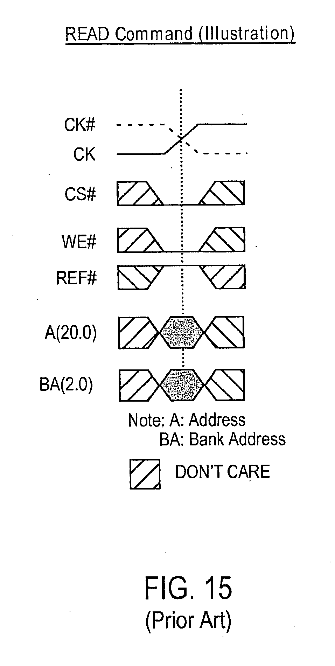

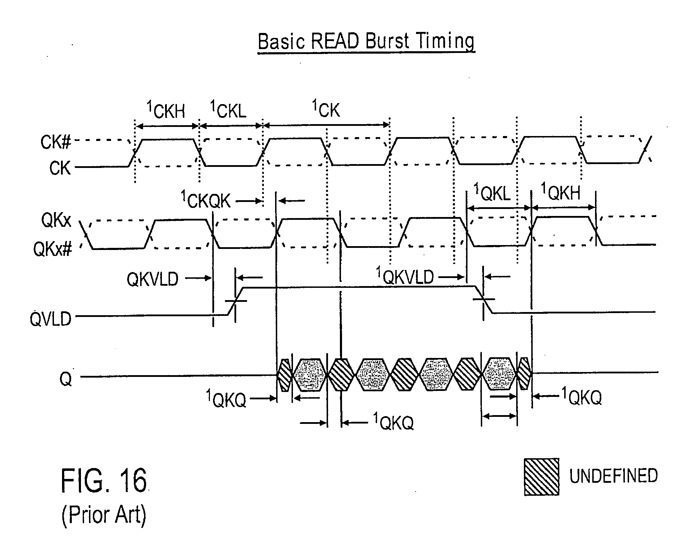

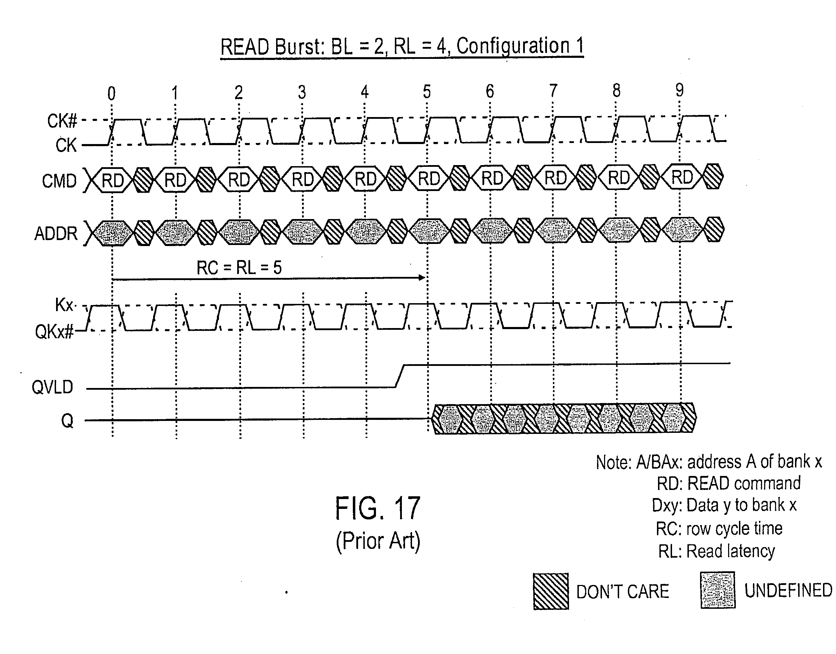

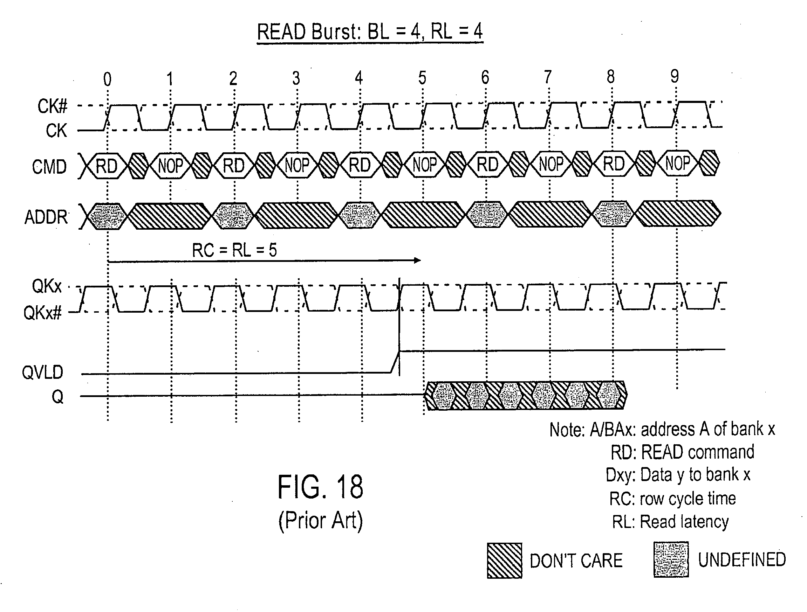

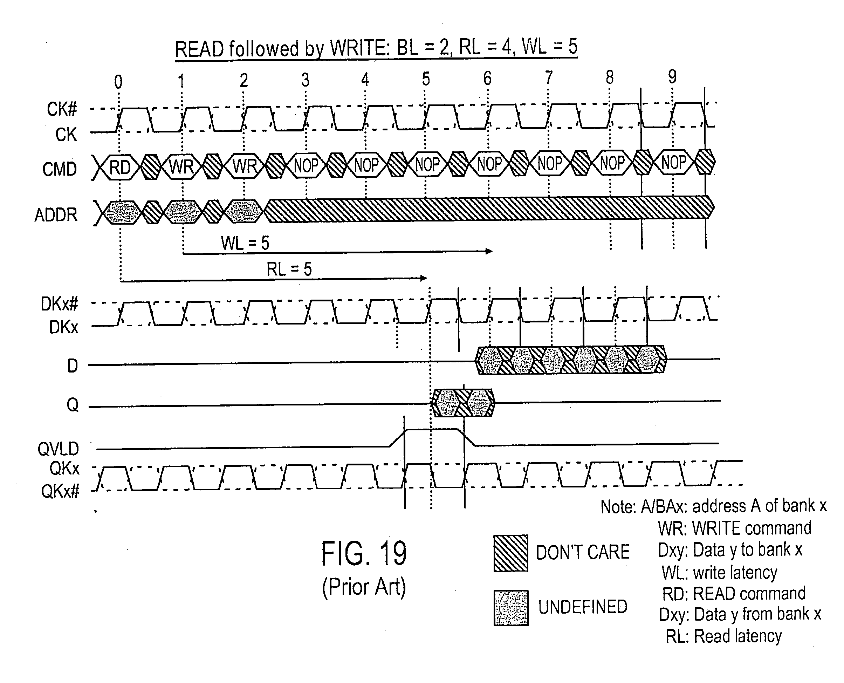

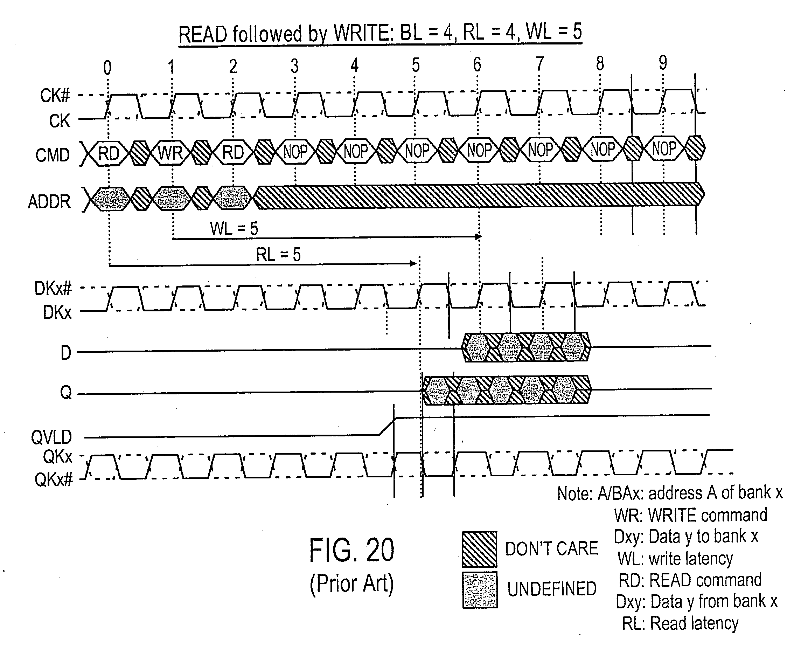

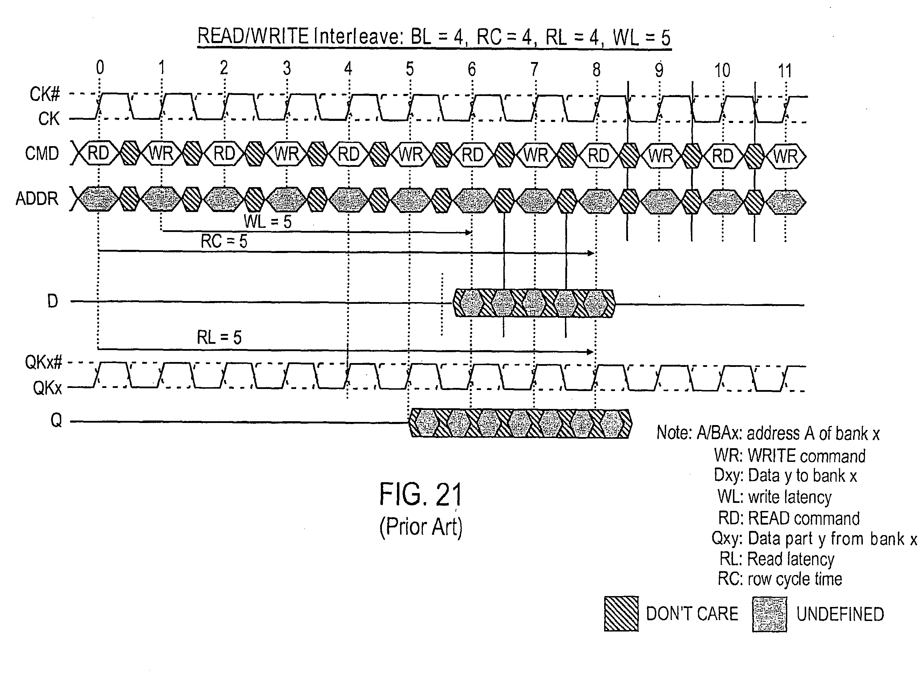

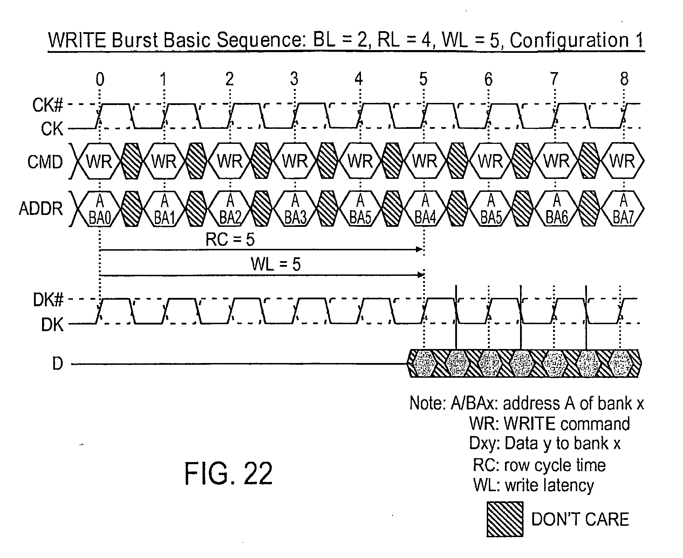

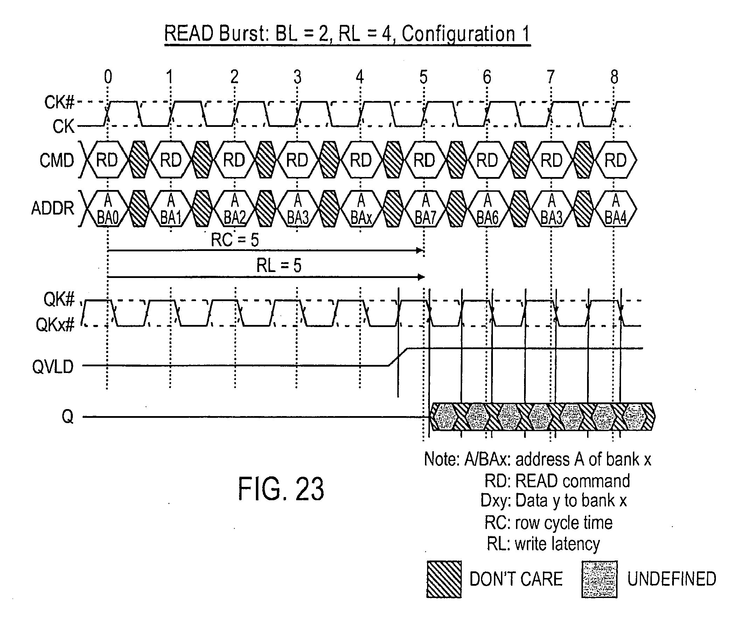

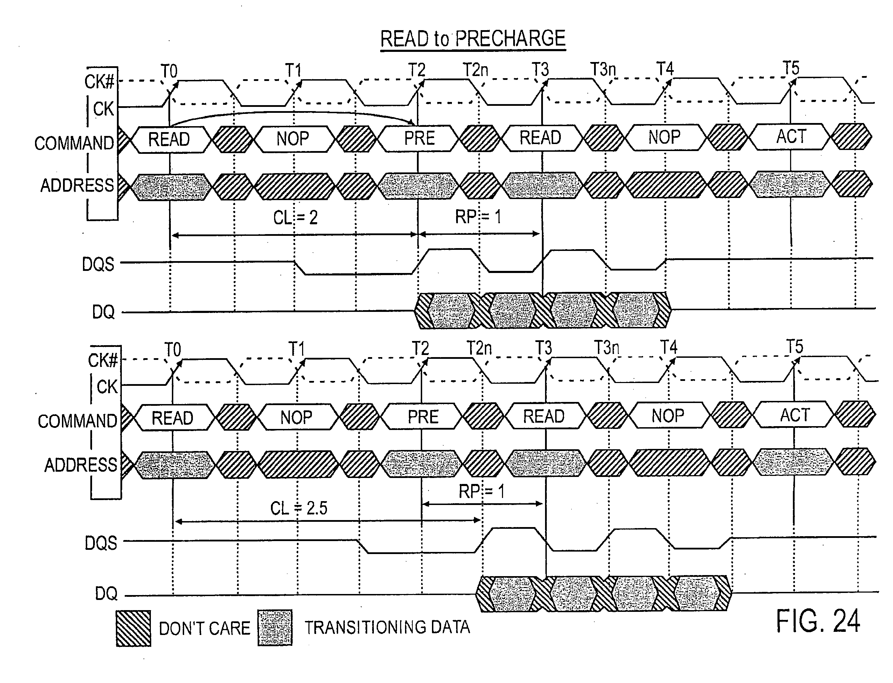

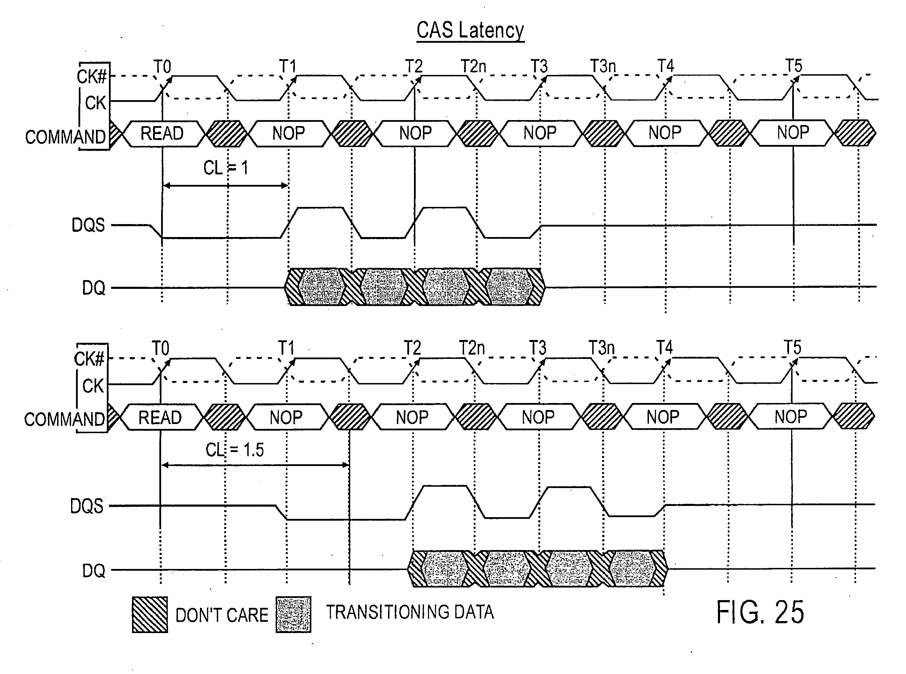

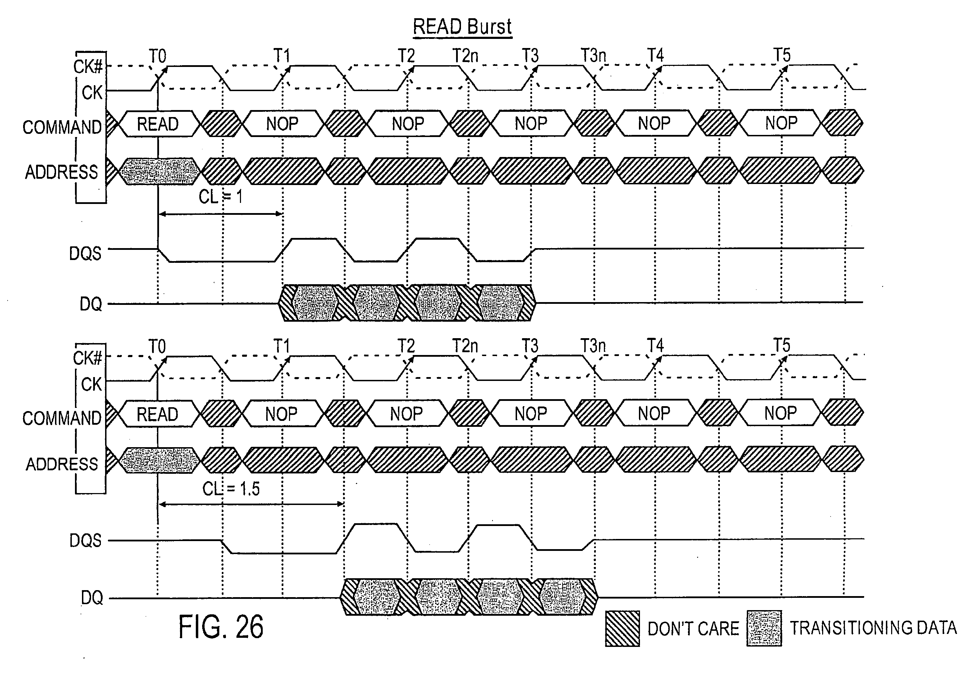

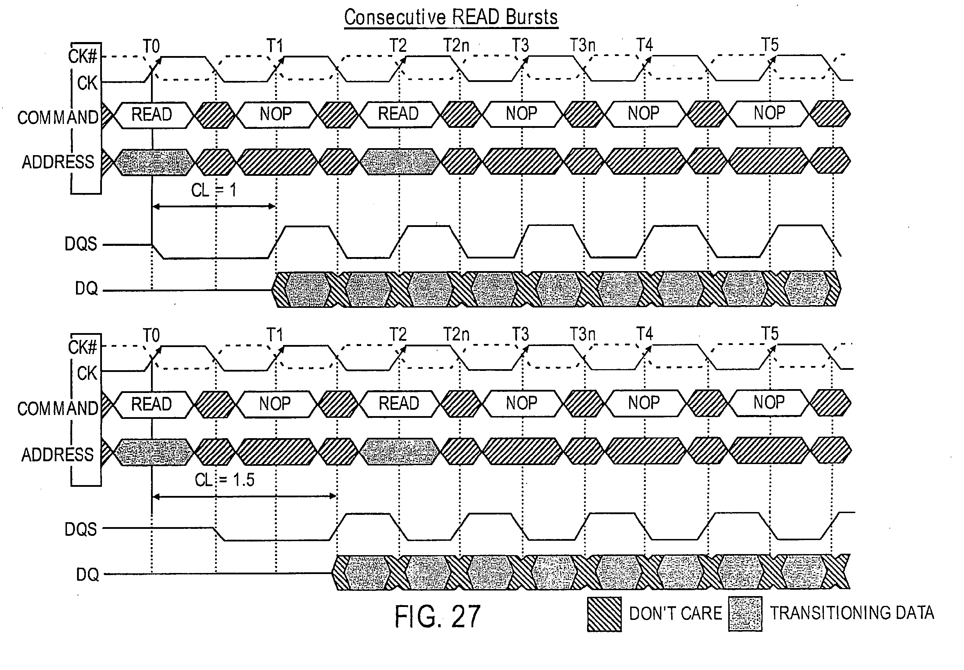

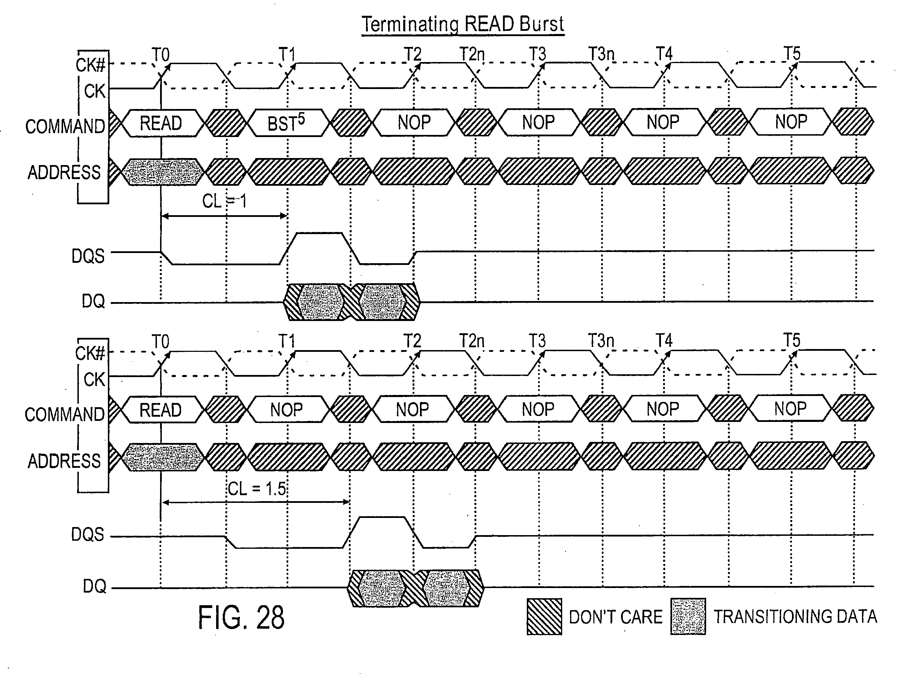

**Figures 10-21** depict timing diagrams of typical DRAM chips well known in the prior art. **Figures 22-28** show improvements over a traditional DDR SDRAM (Synchronous double data rate) DRAM in accordance with various embodiments.

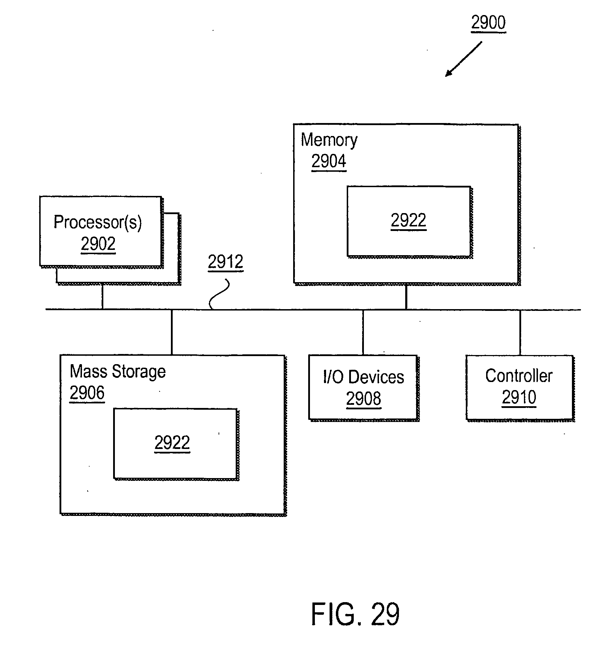

**Figure 29** illustrates an example computer system suitable for use to practice various embodiments of the present invention. As shown, computing system **2900** includes a number of processors or processor cores **2902,** and selective precharge memory **2904.** One or more of processors **2902** may be a digital signal processor. Selective precharge memory **2904** may be, in embodiments, any of the embodiments of digital memory devices described elsewhere in this application, or other embodiments of the present invention. For the purpose of this application, including the claims, the terms "processor" and "processor cores" may be considered synonymous, unless the context clearly requires otherwise. Additionally, computing system **2900** may include mass storage devices **2906** (such as diskette, hard drive, compact disc read only memory (CDROM) and so forth), input/output devices **2908** (such as keyboard, cursor control and so forth) and controller **2910** which may, in embodiments, be a memory controller for controlling the operation of selective precharge memory **2904.** Controller **2910** may, in embodiments, by specially adapted to communicate with selective precharge memory **2904** including, in embodiments, presenting a column address before a row address when issuing an access command to selective precharge memory **2904.** The elements may be coupled to each other via system bus **2912,** which may represent one or more buses. In the case of multiple buses, they may be bridged by one or more bus bridges (not shown). Selective precharge memory **2904** may be used to store a working copy of programming instructions **2922** such as an operating system or other programming instructions.

Each of these elements may perform its conventional function known in the art. In particular, mass storage **2906** may be employed to store a working copy and a permanent copy of programming instructions **2922** such as for an operating system. The constitution of elements **2902, 2906, 2908,** and **2912** are, except as noted above, known, and accordingly will not be further described.

Embodiments of the present invention may be used in any electronic device or system utilizing digital memory including cellular telephones, digital telephones, personal data assistants, laptop computing systems, routers, hubs, switches, line cards, cellular telephones, Personal Data Assistants (PDA), electronic gaming devices, High Definition Televisions (HDTV), as well as industrial devices, automotive devices, and others. Embodiments of the present invention are not limited to any one or set of implementations of communication or other electronic devices. The computer system of Figure 29 is therefore meant to be exemplary only and one of ordinary skill in the art will recognize that embodiments of the present invention are not so limited.

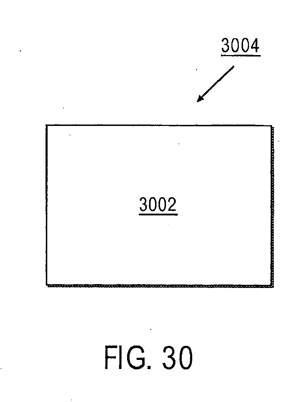

Figure 30 depicts a medium **3004** containing formal or compiled description **3002** of one or more electronic circuits implementing one or more of the embodiments described within this application. Medium **3004** may, in various embodiments, be a CD-ROM, a hard disk drive, a floppy disk, a DVD-ROM, a flash memory device, or other medium known in the art for storing formal description **3002.** Formal description **3002** may, in embodiments, be in VHSIC Hardware Description Language (VHDL), Verilog, or any other such hardware design language appropriate for formally describing electronic circuits implementing one or more of the embodiments described within this application. Compiled format may be in Graphic Data System (GDS), GDS II or other formats.

Although specific embodiments have been illustrated and described herein, it will be appreciated by those of ordinary skill in the art that a wide variety of alternate and/or equivalent implementations may be substituted for the specific embodiments shown and described, without departing from the scope of the embodiments of the present invention. This application is intended to cover any adaptations or variations of the embodiments discussed herein. Therefore, it is manifestly intended that the embodiments of the present invention be limited only by the claims and the equivalents thereof.

## Claims

1. A method of operating digital memory, comprising:
receiving, by a digital memory device including a plurality of memory cells (513, 600) and a plurality of bit lines (509, 607) associated with the memory cells (513), a command to perform an operation on a subset of the plurality of memory cells (513), wherein the subset comprises fewer memory cells (513, 600) than the plurality of memory cells (513, 600);
the digital memory device precharging, on the front end of the operation, only a subset of bit lines (509, 607) associated with the subset of memory cells (513, 600), **characterized by**:
providing for each the memory cell (600) a gating transistor (601) and a precharge select transistor (605).

2. A method as claimed in claim 1, further including:
determining, by the digital memory device, whether a substitute command to perform a substitute operation on the subset of the plurality of memory cells has been received; and
in response to determining that a substitute command has been received, performing, by the digital memory device, the substitute operation on the subset of memory cells without initiating a new access cycle.

3. The method of claim 2, further comprising receiving, by the digital memory device, an identifier and identifying, using at least a portion of the identifier, the subset of the plurality of bit lines.

4. The method of claim 3, wherein both the command and the substitute command are access operation commands, and wherein the subset of the plurality of memory cells is identified by the identifier.

5. The method of claim 4, wherein each gating transistor includes a row line terminal and each precharge select transistor includes a precharge select terminal, and wherein said performing the substitute access operation further comprises fixing, by a row decoder, an access voltage level on a row line coupled to each of the row line terminals and fixing, by a precharge select circuit, a precharge select voltage level on one or more precharge select lines coupled to the precharge select terminals.

6. The method of claim 5, further comprising receiving, by the digital memory device, another command to perform another access operation on another subset of the plurality of memory cells and performing the another access operation on the another subset of the plurality of memory cells, wherein the another subset of the plurality of memory cells comprises at least one memory cell not in the subset of the plurality of memory cells and that is also coupled to the row line, and wherein the another access operation is performed within an access cycle of the substitute access operation.

7. The method of claim 6, further comprising selectively precharging another subset of the bit lines corresponding to the another subset of memory cells substantially during said performing the substitute access operation.

8. An apparatus, comprising:
a plurality of memory cells (513, 600) arranged in a grid including a plurality of columns and a plurality of rows, wherein each one of the plurality of memory cells forms a part of exactly one row and exactly one column of the grid, wherein each memory cell in a column is coupled to each other by a corresponding bit line of a plurality of bit lines, and wherein each memory cell in a row is coupled to each other by a corresponding row line of a plurality of row lines; and
a precharge select circuit operatively coupled to the plurality of bit lines (509, 607) and configured to facilitate, on the front end of an access operation, selective precharging of a subset of the plurality of bit lines (509, 607), wherein the precharging occurs in response to a received command to perform the access operation on a subset of the plurality of memory cells (513, 600) during an access cycle, and wherein the subset of bit lines corresponds to the subset of memory cells (513, 600), **characterized in that**:
the memory cells comprise a gating transistor (601) and a precharge select transistor (605).

9. The apparatus of claim 8, further comprising:
control circuitry coupled to the plurality of memory cells and configured to receive a substitute command to perform a substitute access operation on the subset of memory cells, wherein the substitute access operation is different from the access operation; and
access circuitry coupled to the plurality of memory cells and configured to perform the substitute access operation during the access cycle.

10. The apparatus of claim 9, wherein each precharge select transistor is operatively coupled to the subset of bit lines, and wherein the precharge select circuit is further configured to facilitate selective precharging of the subset of bit lines by activating one of the plurality of precharge select transistors.

11. The apparatus of claim 9, wherein the precharge select circuit is configured to fix a precharge select voltage on a corresponding terminal of the corresponding precharge select transistor to facilitate the precharging of a corresponding bit line of the subset of bit lines, the apparatus further comprises a storage element configured to store a storage voltage level, and wherein each of the plurality of memory cells is further configured to drive a bit voltage on a corresponding bit line of the subset of bit lines upon detecting an access voltage level on a corresponding row line, each gating transistor includes a first terminal operatively coupled to a corresponding bit line of the subset of bit lines, a second terminal operatively coupled to a corresponding row line, and a third terminal operatively coupled to the precharge select transistor, and wherein the precharge select transistor is in series between the gating transistor and the storage element of each of the plurality of memory cells.

12. The apparatus of claim 9, further comprising a column decoder configured to decode a column address of an identifier received by the apparatus, wherein the identifier identifies a subset of memory cells to be accessed, and wherein the column address decoder is further configured to use the decoded column address to signal to the precharge select circuit the subset of bit lines to be selectively precharged.

13. The apparatus of claim 12, wherein the subset of bit lines are associated with at least a subset of the plurality of columns, wherein the subset of columns includes the subset of memory cells to be accessed.

14. The apparatus of claim 9, further comprising a plurality of precharge select lines, wherein each memory cell in a single column is coupled to each of the other memory cells in the single column, and to the precharge select circuit, by a corresponding precharge select line of the plurality of precharge select lines, and wherein each of the plurality of memory cells is configured to activate if both a row line voltage level has been fixed on a corresponding row line of the plurality of rows and a precharge select voltage level has been fixed on a corresponding precharge select line of the plurality of precharge select lines.

15. The apparatus of claim 14, wherein each gating transistor is coupled to the corresponding row lines, each precharge select transistor is coupled to the corresponding precharge select lines, and a storage element is arranged in series with the gating and precharge select transistors.

16. The apparatus of claim 14, wherein the precharge select circuit is configured to fix the precharge select voltage level for a subset of the plurality of precharge select lines.

17. The apparatus of claim 9, further comprising a row decoder and a column decoder, wherein each decoder is operatively coupled to the plurality of memory cells via the row lines, wherein the row decoder is configured to decode a row address of an identifier received by the apparatus, wherein the identifier identifies a row containing the subset of memory cells on which to perform the access operation, wherein the row decoder is further configured to fix an access voltage level on the corresponding row line of the row containing the subset of memory cells on which to perform the access operation, wherein the row and column decoders are complementarily configured to have column addresses provided to the column decoder before the row addresses are provided to the row decoder.

18. The apparatus of claim 9, further comprising a plurality of sense amplifiers each operatively coupled to one of the plurality of bit lines and adapted to read a bit line voltage level after an opening of the circuit, and wherein:
the precharge select circuit is further configured to facilitate, in response to another received command to perform another access operation on another subset of the plurality of memory cells, selective precharging of another subset of bit lines comprising less than all of the plurality of bit lines, wherein the another subset of bit lines includes at least one bit line not in the subset of bit lines, wherein the another subset of the plurality of memory cells includes at least one memory cell not in the subset of the plurality of memory cells and is coupled to a same row line as the subset of the plurality of memory cells, and wherein the precharge select circuit is further configured to facilitate said precharging of the another subset of bit lines while a subset of corresponding sense amplifiers of the plurality of sense amplifiers performs the access operation or the substitute access operation on the subset of the plurality of memory cells, or the plurality of sense amplifiers are configured to be selectively enabled.

## Patentansprüche

1. Verfahren zum Betreiben von digitalem Speicher, das umfasst:
Empfangen mittels einer digitalen Speichervorrichtung, die eine Mehrzahl von Speicherzellen (513, 600) und eine Mehrzahl von Bitleitungen (509, 607), die den Speicherzellen (513) zugeordnet sind, enthält, eines Befehls, um eine Operation an einer Untermenge der Mehrzahl von Speicherzellen (513) auszuführen, wobei die Untermenge weniger Speicherzellen (513, 600) als die Mehrzahl von Speicherzellen (513, 600) enthält;
wobei die digitale Speichervorrichtung am Beginn der Operation nur eine Untermenge von Bitleitungen (509, 607), die der Untermenge von Speicherzellen (513, 600) zugeordnet sind, vorlädt, **gekennzeichnet durch**:
Vorsehen eines Torsteuerungstransistors (601) und eines Vorladeauswahltransistors (605) für jede Speicherzelle (600).

2. Verfahren nach Anspruch 1, das ferner umfasst:
Bestimmen durch die digitale Speichervorrichtung, ob ein Ersatzbefehl zum Ausführen einer Ersatzoperation an der Untermenge der Mehrzahl von Speicherzellen empfangen worden ist; und
in Reaktion auf die Bestimmung, dass ein Ersatzbefehl empfangen worden ist, Ausführen der Ersatzoperation an der Untermenge von Speicherzellen durch die digitale Speichervorrichtung, ohne dass ein neuer Zugriffszyklus begonnen wird.

3. Verfahren nach Anspruch 2, das ferner das Empfangen durch die digitale Speichervorrichtung eines Identifizierers und das Identifizieren unter Verwendung wenigstens eines Abschnitts des Identifizierers der Untermenge der Mehrzahl von Bitleitungen umfasst.

4. Verfahren nach Anspruch 3, wobei sowohl der Befehl als auch der Ersatzbefehl Zugriffsoperationsbefehle sind und wobei die Untermenge der Mehrzahl von Speicherzellen durch den Identifizierer identifiziert wird.

5. Verfahren nach Anspruch 4, wobei jeder Torsteuerungstransistor einen Zeilenleitungsanschluss enthält und jeder Vorladeauswahltransistor einen Vorladeauswahlanschluss enthält und wobei das Ausführen der Ersatzzugriffsoperation ferner das Festlegen durch einen Zeilendecodierer eines Zugriffsspannungspegels auf der Zeilenleitung, die mit jedem der Zeilenleitungsanschlüsse gekoppelt ist, und das Festlegen durch eine Vorladeauswahlschaltung eines Vorladeauswahl-Spannungspegels auf einer Vorladeauswahlleitung oder auf einer Mehrzahl von Vorladeauswahlleitungen, die mit den Vorladeauswahlanschlüssen gekoppelt ist bzw. sind, umfasst.

6. Verfahren nach Anspruch 5, das ferner das Empfangen durch die digitale Speichervorrichtung eines weiteren Befehls zum Ausführen einer weiteren Zugriffsoperation an einer weiteren Untermenge der Mehrzahl von Speicherzellen und das Ausführen der weiteren Zugriffsoperation an der weiteren Untermenge der Mehrzahl von Speicherzellen umfasst, wobei die weitere Untermenge der Mehrzahl von Speicherzellen wenigstens eine Speicherzelle enthält, die nicht in der Untermenge der Mehrzahl von Speicherzellen enthalten ist und die ebenfalls mit der Zeilenleitung gekoppelt ist, und wobei die weitere Zugriffsoperation in einem Zugriffszyklus der Ersatzzugriffsoperation ausgeführt wird.

7. Verfahren nach Anspruch 6, das ferner das wahlweise Vorladen einer weiteren Untermenge der Bitleitungen, die der weiteren Untermenge von Speicherzellen entspricht, im Wesentlichen während des Ausführens der Ersatzzugriffsoperation umfasst.

8. Vorrichtung, die umfasst:
eine Mehrzahl von Speicherzellen (513, 600), die in einem Gitter angeordnet sind, das eine Mehrzahl von Spalten und eine Mehrzahl von Zeilen enthält, wobei jede der Mehrzahl von Speicherzellen einen Teil von exakt einer Zeile und exakt einer Spalte des Gitters bildet, wobei die einzelnen Speicherzellen in einer Spalte durch eine entsprechende Bitleitung einer Mehrzahl von Bitleitungen miteinander gekoppelt sind und wobei die einzelnen Speicherzellen in einer Zeile durch eine entsprechende Zeilenleitung einer Mehrzahl von Zeilenleitungen miteinander gekoppelt sind; und
eine Vorladeauswahlschaltung, die mit den Mehrzahl von Bitleitungen (509, 607) funktional gekoppelt ist und konfiguriert ist, um am vorderen Ende einer Zugriffsoperation das wahlweise Vorladen einer Untermenge der Mehrzahl von Bitleitungen (509, 607) zu erleichtern, wobei das Vorladen in Reaktion auf einen empfangenen Befehl zum Ausführen der Zugriffsoperation an einer Untermenge der Mehrzahl von Speicherzellen (513, 600) während eines Zugriffszyklus erfolgt und wobei die Untermenge von Bitleitungen der Untermenge von Speicherzellen (513, 600) entspricht, **dadurch gekennzeichnet, dass**:
die Speicherzellen einen Torsteuerungstransistor (601) und einen Vorladeauswahltransistor (605) umfassen.

9. Vorrichtung nach Anspruch 8, die ferner umfasst:
eine Steuerschaltungsanordnung, die mit den Mehrzahl von Speicherzellen gekoppelt ist und konfiguriert ist, um einen Ersatzbefehl zu empfangen, um eine Ersatzzugriffsoperation an der Untermenge von Speicherzellen auszuführen, wobei die Ersatzzugriffsoperation von der Zugriffsoperation verschieden ist; und
eine Zugriffsschaltungsanordnung, die mit den Mehrzahl von Speicherzellen gekoppelt ist und konfiguriert ist, um die Ersatzzugriffsoperation während des Zugriffszyklus auszuführen.

10. Vorrichtung nach Anspruch 9, wobei jeder Vorladeauswahltransistor mit der Untermenge von Bitleitungen funktional gekoppelt ist und wobei die Vorladeauswahlschaltung ferner konfiguriert ist, um das wahlweise Vorladen der Untermenge von Bitleitungen durch Aktivieren eines der Mehrzahl von Vorladeauswahltransistoren zu erleichtern.

11. Vorrichtung nach Anspruch 9, wobei die Vorladeauswahlschaltung konfiguriert ist, um eine Vorladeauswahlspannung an einem entsprechenden Anschluss des entsprechenden Vorladeauswahltransistors festzulegen, um das Vorladen einer entsprechenden Bitleitung der Untermenge von Bitleitungen zu erleichtern, wobei die Vorrichtung ferner ein Speicherelement umfasst, das konfiguriert ist, um einen Speicherspannungspegel zu speichern, und wobei jede der Mehrzahl von Speicherzellen ferner konfiguriert ist, um eine Bitspannung an einer entsprechenden Bitleitung der Untermenge von Bitleitungen anzusteuern, wenn ein Zugriffsspannungspegel auf einer entsprechenden Zeilenleitung detektiert wird, wobei jeder Torsteuerungstransistor einen ersten Anschluss, der mit einer entsprechenden Bitleitung der Untermenge von Bitleitungen funktional gekoppelt ist, einen zweiten Anschluss, der mit einer entsprechenden Zeilenleitung funktional gekoppelt ist, und einen dritten Anschluss, der mit dem Vorladeauswahltransistor funktional gekoppelt ist, umfasst und wobei der Vorladeauswahltransistor zwischen dem Torsteuerungstransistor und dem Speicherelement jeder der Mehrzahl von Speicherzellen in Reihe geschaltet ist.

12. Vorrichtung nach Anspruch 9, die ferner einen Spaltendecodierer umfasst, der konfiguriert ist, um eine Spaltenadresse eines von der Vorrichtung empfangenen Identifizierers zu decodieren, wobei der Identifizierer eine Untermenge von Speicherzellen, auf die zugegriffen werden soll identifiziert, und wobei der Spaltenadressen-Decodierer ferner konfiguriert ist, um die decodierte Spaltenadresse dazu zu verwenden, der Vorladeauswahlschaltung die Untermenge von Bitleitungen, die wahlweise vorgeladen werden sollen, zu melden.

13. Vorrichtung nach Anspruch 12, wobei die Untermenge von Bitleitungen wenigstens einer Untermenge der Mehrzahl von Spalten zugeordnet ist, wobei die Untermenge von Spalten die Untermenge von Speicherzellen, auf die zugegriffen werden soll, enthält.

14. Vorrichtung nach Anspruch 9, die ferner eine Mehrzahl von Vorladeauswahlleitungen umfasst, wobei jede Speicherzelle in einer einzelnen Spalte mit jeder der anderen Speicherzellen in der einzelnen Spalte und mit der Vorladeauswahlschaltung durch eine entsprechende Vorladauswahlleitung der Mehrzahl von Vorladeauswahlleitungen gekoppelt ist und wobei jede der Mehrzahl von Speicherzellen konfiguriert ist, um aktiviert zu werden, wenn sowohl ein Zeilenleitungs-Spannungspegel auf einer entsprechenden Zeilenleitung der Mehrzahl von Zeilen als auch ein Vorladeauswahl-Spannungspegel auf einer entsprechenden Vorladeauswahlleitung der Mehrzahl von Vorladeauswahlleitungen festgelegt worden sind.

15. Vorrichtung nach Anspruch 14, wobei jeder Torsteuerungstransistor mit den entsprechenden Zeilenleitungen gekoppelt ist, jeder Vorladeauswahltransistor mit den entsprechenden Vorladeauswahlleitungen gekoppelt ist und ein Speicherelement in Reihe mit den Torsteuerungs- und Vorladeauswahltransistoren geschaltet ist.

16. Vorrichtung nach Anspruch 14, wobei die Vorladeauswahlschaltung konfiguriert ist, um den Vorladeauswahl-Spannungspegel für eine Untermenge der Mehrzahl von Vorladauswahlleitungen festzulegen.

17. Vorrichtung nach Anspruch 9, die ferner einen Zeilendecodierer und einen Spaltendecodierer umfasst, wobei jeder Decodierer mit den Mehrzahl von Speicherzellen über die Zeilenleitungen funktional gekoppelt ist, wobei der Zeilendecodierer konfiguriert ist, um eine Zeilenadresse eines von der Vorrichtung empfangenen Identifizierers zu decodieren, wobei der Identifizierer eine Zeile, die die Untermenge von Speicherzellen enthält, an denen die Zugriffsoperation ausgeführt werden soll, identifiziert, wobei der Zeilendecodierer ferner konfiguriert ist, um einen Zugriffsspannungspegel auf der entsprechenden Zeilenleitung der Zeile, die die Untermenge von Speicherzellen enthält, an denen die Zugriffsoperation ausgeführt werden soll, festzulegen, wobei die Zeilen- und Spaltendecodierer komplementär konfiguriert sind, so dass die Spaltenadressen für den Spaltendecodierer bereitgestellt werden, bevor die Zeilenadressen für den Zeilendecodierer bereitgestellt werden.

18. Vorrichtung nach Anspruch 9, die ferner eine Mehrzahl von Leseverstärkern umfasst, wovon jeder mit einer der Mehrzahl von Bitleitungen gekoppelt ist und dazu ausgelegt ist, nach einem Öffnen der Schaltung einen Bitleitungs-Spannungspegel zu lesen, und wobei:
die Vorladeauswahlschaltung ferner konfiguriert ist, um in Reaktion auf einen weiteren empfangenen Befehl, um eine weitere Zugriffsoperation an einer weiteren Untermenge der Mehrzahl von Speicherzellen auszuführen, das wahlweise Vorladen einer weiteren Untermenge von Bitleitungen, die weniger als alle der Mehrzahl von Bitleitungen enthält, zu erleichtern, wobei die weitere Untermenge von Bitleitungen wenigstens eine Bitleitung enthält, die nicht in der Untermenge von Bitleitungen enthalten ist, wobei die weitere Untermenge der Mehrzahl von Speicherzellen wenigstens eine Speicherzelle enthält, die nicht in der Untermenge der Mehrzahl von Speicherzellen enthalten ist, und mit derselben Zeilenreihe wie die Untermenge der Mehrzahl von Speicherzellen gekoppelt ist, und wobei die Vorladeauswahlschaltung ferner konfiguriert ist, um das Vorladen der weiteren Untermenge von Bitleitungen zu erleichtern, während eine Untermenge entsprechender Leseverstärker der Mehrzahl von Leseverstärkern die Zugriffsoperation oder die Ersatzzugriffsoperation an der Untermenge der Mehrzahl von Speicherzellen ausführt oder die Mehrzahl von Leseverstärkern konfiguriert sind, um wahlweise freigegeben zu werden.

## Revendications

1. Procédé de mise en oeuvre d'une mémoire numérique, consistant à :
recevoir, par un dispositif de mémoire numérique comprenant une pluralité de cellules de mémoire (513, 600) et une pluralité de lignes de bit (509, 607) associées aux cellules de mémoire (513), une commande pour effectuer une opération sur un sous-ensemble de la pluralité de cellules de mémoire (513), dans lequel le sous-ensemble comprend moins de cellules de mémoire (513, 600) que la pluralité de cellules de mémoire (513, 600) ;
le dispositif de mémoire numérique préchargeant, à l'extrémité avant de l'opération, seulement un sous-ensemble de lignes de bit (509, 607) associées au sous-ensemble de cellules de mémoire (513, 600), **caractérisé par** :
la prévision, pour chaque cellule de mémoire (600), un transistor de commande (601) et un transistor de sélection de précharge (605).

2. Procédé selon la revendication 1, consistant en outre à :
déterminer, par le dispositif de mémoire numérique, si une commande de substitution pour effectuer une opération de substitution sur le sous-ensemble de la pluralité de cellules de mémoire a été reçue ; et
en réponse à la détermination qu'une commande de substitution a été reçue, effectuer, par le dispositif de mémoire numérique, l'opération de substitution sur le sous-ensemble de cellules de mémoire sans lancer un nouveau cycle d'accès.

3. Procédé selon la revendication 2, consistant en outre à recevoir, par le dispositif de mémoire numérique, un identifiant et identifier, en utilisant au moins une partie de l'identifiant, le sous-ensemble de la pluralité de lignes de bit.

4. Procédé selon la revendication 3, dans lequel la commande et la commande de substitution sont toutes deux des commandes d'opération d'accès, et dans lequel le sous-ensemble de la pluralité de cellules de mémoire est identifié par l'identifiant.

5. Procédé selon la revendication 4, dans lequel chaque transistor de commande comprend une borne de ligne de rangée et chaque transistor de sélection de précharge comprend une borne de sélection de précharge, et dans lequel ladite exécution de l'opération d'accès de substitution consiste en outre à fixer, par un décodeur de rangée, un niveau de tension d'accès sur une ligne de rangée couplée à chacune des bornes de ligne de rangée et fixer, par un circuit de sélection de précharge, un niveau de tension de sélection de précharge sur une ou plusieurs lignes de sélection de précharge couplées aux bornes de sélection de précharge.

6. Procédé selon la revendication 5, consistant en outre à recevoir, par le dispositif de mémoire numérique, une autre commande pour effectuer une autre opération d'accès sur un autre sous-ensemble de la pluralité de cellules de mémoire et effectuer l'autre opération d'accès sur l'autre sous-ensemble de la pluralité de cellules de mémoire, dans lequel l'autre sous-ensemble de la pluralité de cellules de mémoire comprend au moins une cellule de mémoire qui n'est pas dans le sous-ensemble de la pluralité de cellules de mémoire et qui est également couplée à la ligne de rangée, et dans lequel l'autre opération d'accès est effectuée dans un cycle d'accès de l'opération d'accès de substitution.

7. Procédé selon la revendication 6, consistant en outre à précharger de manière sélective un autre sous-ensemble des lignes de bit correspondant à l'autre sous-ensemble de cellules de mémoire sensiblement pendant ladite exécution de l'opération d'accès de substitution.

8. Dispositif, comprenant :
une pluralité de cellules de mémoire (513, 600) agencées en une grille comprenant une pluralité de colonnes et une pluralité de rangées, dans lequel chacune de la pluralité de cellules de mémoire forme une partie d'exactement une rangée et d'exactement une colonne de la grille, dans lequel toutes les cellules de mémoire dans une colonne sont couplées les unes aux autres par une ligne de bit correspondante d'une pluralité de lignes de bit, et dans lequel toutes les cellules de mémoire dans une rangée sont couplées les unes aux autres par une ligne de rangée correspondante d'une pluralité de lignes de rangée ; et
un circuit de sélection de précharge couplé fonctionnellement à la pluralité de lignes de bit (509, 607) et configuré pour faciliter, à l'extrémité avant d'une opération d'accès, la précharge sélective d'un sous-ensemble de la pluralité de lignes de bit (509, 607), dans lequel la précharge est effectuée en réponse à une commande reçue pour effectuer l'opération d'accès sur un sous-ensemble de la pluralité de cellules de mémoire (513, 600) pendant un cycle d'accès, et dans lequel le sous-ensemble de lignes de bit correspond au sous-ensemble de cellules de mémoire (513, 600), **caractérisé en ce que** :
les cellules de mémoire comprennent un transistor de commande (601) et un transistor de sélection de précharge (605).

9. Dispositif selon la revendication 8, comprenant en outre :
des éléments de circuit de commande couplés à la pluralité de cellules de mémoire et configurés pour recevoir une commande de substitution pour effectuer une opération d'accès de substitution sur le sous-ensemble de cellules de mémoire, dans lequel l'opération d'accès de substitution est différente de l'opération d'accès ; et
des éléments de circuit d'accès couplés à la pluralité de cellules de mémoire et configurés pour effectuer l'opération d'accès de substitution pendant le cycle d'accès.

10. Dispositif selon la revendication 9, dans lequel chaque transistor de sélection de précharge est couplé fonctionnellement au sous-ensemble de lignes de bit, et dans lequel le circuit de sélection de précharge est en outre configuré pour faciliter la précharge sélective du sous-ensemble de lignes de bit en activant l'un de la pluralité de transistors de sélection de précharge.

11. Dispositif selon la revendication 9, dans lequel le circuit de sélection de précharge est configuré pour fixer une tension de sélection de précharge sur une borne correspondante du transistor de sélection de précharge correspondant pour faciliter la précharge d'une ligne de bit correspondante du sous-ensemble de lignes de bit, le dispositif comprend en outre un élément de stockage configuré pour stocker un niveau de tension de stockage, et dans lequel chacune de la pluralité de cellules de mémoire est en outre configurée pour commander une tension de bit sur une ligne de bit correspondante du sous-ensemble de lignes de bit lors de la détection d'un niveau de tension d'accès sur une ligne de rangée correspondante, chaque transistor de commande comprend une première borne couplée fonctionnellement à une ligne de bit correspondante du sous-ensemble de lignes de bit, une deuxième borne couplée fonctionnellement à une ligne de rangée correspondante, et une troisième borne couplée fonctionnellement au transistor de sélection de précharge, et dans lequel le transistor de sélection de précharge est en série entre le transistor de commande et l'élément de stockage de chacune de la pluralité de cellules de mémoire.

12. Dispositif selon la revendication 9, comprenant en outre un décodeur de colonne configuré pour décoder une adresse de colonne d'un identifiant reçu par le dispositif, dans lequel l'identifiant identifie un sous-ensemble de cellules de mémoire devant faire l'objet d'un accès, et dans lequel le décodeur d'adresse de colonne est en outre configuré pour utiliser l'adresse de colonne décodée pour signaler au circuit de sélection de précharge le sous-ensemble de lignes de bit à précharger de manière sélective.

13. Dispositif selon la revendication 12, dans lequel le sous-ensemble de lignes de bit est associé à au moins un sous-ensemble de la pluralité de colonnes, dans lequel le sous-ensemble de colonnes comprend le sous-ensemble de cellules de mémoire devant faire l'objet d'un accès.

14. Dispositif selon la revendication 9, comprenant en outre une pluralité de lignes de sélection de précharge, dans lequel chaque cellule de mémoire dans une colonne unique est couplée à chacune des autres cellules de mémoire dans la colonne unique, et au circuit de sélection de précharge, par une ligne de sélection de précharge correspondante de la pluralité de lignes de sélection de précharge, et dans lequel chacune de la pluralité de cellules de mémoire est configurée pour s'activer si à la fois un niveau de tension de ligne de rangée a été fixé sur une ligne de rangée correspondante de la pluralité de rangées et un niveau de tension de sélection de précharge a été fixé sur une ligne de sélection de précharge correspondante de la pluralité de lignes de sélection de précharge.

15. Dispositif selon la revendication 14, dans lequel chaque transistor de commande est couplé aux lignes de rangée correspondantes, chaque transistor de sélection de précharge est couplé aux lignes de sélection de précharge correspondantes, et un élément de stockage est agencé en série avec les transistors de commande et de sélection de précharge.

16. Dispositif selon la revendication 14, dans lequel le circuit de sélection de précharge est configuré pour fixer le niveau de tension de sélection de précharge pour un sous-ensemble de la pluralité de lignes de sélection de précharge.

17. Dispositif selon la revendication 9, comprenant en outre un décodeur de rangée et un décodeur de colonne, dans lequel chaque décodeur est couplé fonctionnellement à la pluralité de cellules de mémoire par l'intermédiaire des lignes de rangée, dans lequel le décodeur de rangée est configuré pour décoder une adresse de rangée d'un identifiant reçu par le dispositif, dans lequel l'identifiant identifie une rangée contenant le sous-ensemble de cellules de mémoire sur lequel l'opération d'accès doit être effectuée, dans lequel le décodeur de rangée est en outre configuré pour fixer un niveau de tension d'accès sur la ligne de rangée correspondante de la rangée contenant le sous-ensemble de cellules de mémoire sur lequel l'opération d'accès doit être effectuée, dans lequel les décodeurs de rangée et de colonne sont configurés de manière complémentaire pour que les adresses de colonne soient fournies au décodeur de colonne avant que les adresses de rangée soient fournies au décodeur de rangée.

18. Dispositif selon la revendication 9, comprenant en outre une pluralité d'amplificateurs de détection couplés chacun fonctionnellement à l'une de la pluralité de lignes de bit et adaptés pour lire un niveau de tension de ligne de bit après une ouverture du circuit, et dans lequel :
le circuit de sélection de précharge est en outre configuré pour faciliter, en réponse à une autre commande reçue pour effectuer une autre opération d'accès sur un autre sous-ensemble de la pluralité de cellules de mémoire, la précharge sélective d'un autre sous-ensemble de lignes de bit comprenant moins que la totalité de la pluralité de lignes de bit, dans lequel l'autre sous-ensemble de lignes de bit comprend au moins une ligne de bit qui n'est pas dans le sous-ensemble de lignes de bit, dans lequel l'autre sous-ensemble de la pluralité de cellules de mémoire comprend au moins une cellule de mémoire qui n'est pas dans le sous-ensemble de la pluralité de cellules de mémoire et qui est couplée à une même ligne de rangée que le sous-ensemble de la pluralité de cellules de mémoire, et dans lequel le circuit de sélection de précharge est en outre configuré pour faciliter ladite précharge de l'autre sous-ensemble de lignes de bit tandis qu'un sous-ensemble d'amplificateurs de détection correspondants de la pluralité d'amplificateurs de détection effectue l'opération d'accès ou l'opération d'accès de substitution sur le sous-ensemble de la pluralité de cellules de mémoire, ou la pluralité d'amplificateurs de détection sont configurés pour être activés de manière sélective.
